# EUROPEAN PATENT APPLICATION

(11) **EP 4 791 158 A1**
(43) Date of publication of application: **12.08.2026**
(21) Application number: 25220474.8
(22) Date of filing: 03.12.2025
(51) Int. Cl.: H10K 50/19, H10K 59/12, H10K 59/122, H10K 59/32, H10K 71/13

(54) **DISPLAY DEVICE, ELECTRONIC DEVICE INCLUDING THE SAME, AND METHOD OF MANUFACTURING THE DISPLAY DEVICE**

(30) Priority: 11.02.2025 KR 20250017526
(71) Applicant: Samsung Display Co., Ltd., Yongin-si, Gyeonggi-do 17113 (KR)
(72) Inventor: Lee, Dayoung, 17113 Yongin-si, Gyeonggi-do (KR); Kim, Kyongsub, 17113 Yongin-si, Gyeonggi-do (KR); Kang, Jingoo, 17113 Yongin-si, Gyeonggi-do (KR); Lee, Arong, 17113 Yongin-si, Gyeonggi-do (KR); Kwak, Donghoon, 17113 Yongin-si, Gyeonggi-do (KR)
(74) Representative: Gulde & Partner

(57) **Abstract**

A display device includes a substrate, a pixel circuit disposed on the substrate, a pixel electrode disposed on the pixel circuit, a bank layer including a bank portion disposed on the pixel electrode and defining a bank opening exposing the pixel electrode from the bank portion, a first-first emission layer accommodated in the bank opening and disposed on the pixel electrode, a charge generation layer accommodated in the bank opening and disposed on the first-first emission layer, a first-second emission layer accommodated in the bank opening and disposed on the charge generation layer, and an opposite electrode covering the bank portion and disposed on the first-second emission layer.

## Description

### BACKGROUND

### 1. Field

Embodiments relate to a device and method, and more particularly, to a display device, an electronic device, and a method of manufacturing the display device.

### 2. Description of the Related Art

Mobility-based electronic devices are widely used. In addition to relatively small electronic devices such as mobile phones, tablet personal computers are being widely used in recent years as mobile electronic devices.

A mobile electronic device includes a display device that provides visual information, such as an image or a video, to a user to support various functions. Recently, as the size of other components for driving a display device is being reduced, the proportion of the display device in an electronic device is gradually increasing, and a structure that may be bent by a predetermined angle from a flat state is being developed.

### SUMMARY

Embodiments include a display device in which a mixing phenomenon of an electron transport layer and a hole transport layer is reduced and a short-circuit phenomenon of an opposite electrode is reduced.

However, these objectives are examples, and the scope of the disclosure is not limited thereto.

Additional features will be set forth in part in the description which follows and, in part, will be apparent from the description, or may be learned by practice of the presented embodiments of the disclosure.

According to a first aspect of the disclosure, a display device includes a substrate, a pixel circuit disposed on the substrate, a pixel electrode disposed on the pixel circuit, a bank layer including a bank portion disposed on the pixel electrode and defining a bank opening exposing the pixel electrode from the bank portion, a first-first emission layer accommodated in the bank opening and disposed on the pixel electrode, a charge generation layer accommodated in the bank opening and disposed on the first-first emission layer, a first-second emission layer accommodated in the bank opening and disposed on the charge generation layer, and an opposite electrode covering the bank portion and disposed on the first-second emission layer, where the charge generation layer includes an n-type charge generation layer, a metal intermediate layer disposed on the n-type charge generation layer, and a p-type charge layer generation disposed on the metal intermediate layer, the bank portion includes a first bank portion reverse-tapered with respect to the substrate and a second bank portion disposed on the first bank portion and tapered with respect to the substrate.

In one embodiment, the opposite electrode may be spaced apart from a side surface of the first bank portion and may contact a side surface of the second bank portion.

In an embodiment, the opposite electrode may be in direct contact with an upper surface of the second bank portion.

In an embodiment, the first-first emission layer may contact the side surface of the first bank portion, and the first-second emission layer may contact the side surface of the second bank portion.

In an embodiment, each of the first-first emission layer, the charge generation layer, and the first-second emission layer may be spaced apart from an upper surface of the second bank portion.

In an embodiment, the display device may further include a first hole transport layer disposed between the pixel electrode and the first-first emission layer, a first electron transport layer disposed between the first-first emission layer and the charge generation layer, a second hole transport layer disposed between the charge generation layer and the first-second emission layer, and a second electron transport layer disposed between the first-second emission layer and the opposite electrode.

In an embodiment, each of the first hole transport layer, the first electron transport layer, the second hole transport layer, and the second electron transport layer may be spaced apart from an upper surface of the second bank portion.

According to a second aspect of the disclosure, an electronic device includes a display device in which a plurality of pixels is disposed, the display device includes a substrate, a pixel circuit disposed on the substrate, a pixel electrode disposed on the pixel circuit, a bank layer including a bank portion disposed on the pixel electrode and defining a bank opening exposing the pixel electrode from the bank portion, a first-first emission layer accommodated in the bank opening and disposed on the pixel electrode, a charge generation layer accommodated in the bank opening and disposed on the first-first emission layer, a first-second emission layer accommodated in the bank opening and disposed on the charge generation layer, and an opposite electrode covering the bank portion and disposed on the first-second emission layer, where the charge generation layer includes an n-type charge generation layer, a metal intermediate layer disposed on the n-type charge generation layer, and a p-type charge generation layer disposed on the metal intermediate layer, the bank portion includes a first bank portion reverse-tapered with respect to the substrate and a second bank portion disposed on the first bank portion and tapered with respect to the substrate.

In one embodiment, ]the opposite electrode may be in direct contact with an upper surface of the second bank portion.

In an embodiment, the opposite electrode may be spaced apart from a side surface of the first bank portion and may contact a side surface of the second bank portion.

In an embodiment, the metal intermediate layer may include at least one material from aluminum and molybdenum.

In an embodiment, in a cross-sectional view, an angle between a side surface of the first bank portion and an upper surface of the substrate may be 90 degrees or more and 130 degrees or less, and/or, in the cross-sectional view, an angle between a side surface of the second bank portion and the upper surface of the substrate may be 60 degrees or more and 70 degrees or less. In an embodiment, in a cross-sectional view, an angle between the first bank portion and the substrate may be 90 degrees or more and 130 degrees or less, and, in the cross-sectional view, an angle between the second bank portion and the substrate may be 60 degrees or more and 70 degrees or less.

According to a third aspect of the disclosure, a method of manufacturing a display device includes disposing a pixel circuit on a substrate, disposing a pixel electrode on the pixel circuit, disposing a bank material on the pixel electrode, defining a bank opening in the bank material to expose at least a portion of the pixel electrode, disposing a first-first emission layer on the pixel electrode to be accommodated in the bank opening, disposing a metal intermediate layer on the bank material so that at least a portion of the metal intermediate layer is disposed on the first-first emission layer, disposing a mask material in the bank opening to cover the metal intermediate layer, removing a portion of the metal intermediate layer disposed on an upper surface of the bank material, removing the mask material, forming a bank layer by etching the bank material, disposing a first-second emission layer on the metal intermediate layer to be accommodated in the bank opening, and disposing an opposite electrode on the bank layer.

In an embodiment, the disposing of the first-first emission layer and the disposing of the first-second emission layer may be performed by an inkjet process.

In an embodiment, in the disposing of the first-first emission layer, the first-first emission layer may be spaced apart from the upper surface of the bank material.

In an embodiment, in the disposing of the first-second emission layer, the first-second emission layer may be spaced apart from the upper surface of the bank material.

In an embodiment, the disposing of the metal intermediate layer may be performed by a deposition process.

In an embodiment, in the disposing of the metal intermediate layer, a portion of the metal intermediate layer may be disposed on the upper surface of the bank material.

In an embodiment, the forming of the bank layer may include forming a first bank portion reverse-tapered with respect to the substrate and a second bank portion disposed on the first bank portion and tapered with respect to the substrate.

In an embodiment, in the disposing of the opposite electrode, the opposite electrode may be spaced apart from a side surface of the first bank portion and may contact a side surface of the second bank portion.

In an embodiment, in the disposing of the opposite electrode, the opposite electrode may be in direct contact with an upper surface of the second bank portion.

In an embodiment, in the disposing of the first-first emission layer, the first-first emission layer may contact a side surface of the first bank portion, and, in the disposing of the first-second emission layer, the first-second emission layer may contact a side surface of the second bank portion.

Other features and advantages other than those described above will now become apparent from the following drawings, claims, and the detailed description of the disclosure.

### BRIEF DESCRIPTION OF THE DRAWINGS

The above and other features and advantages of illustrative embodiments of the disclosure will be more apparent from the following description taken in conjunction with the accompanying drawings, in which:
FIGS. 1 and 2 are schematic plan views of an embodiment of a display device;
FIG. 3 is a circuit diagram schematically illustrating an embodiment of a light-emitting diode provided in a pixel of a display device and a pixel circuit connected to the light-emitting diode;
FIG. 4 is a schematic cross-sectional view of an embodiment of a structure of an organic light-emitting diode;
FIG. 5 is a diagram showing an energy band diagram of a charge generation layer;
FIGS. 6 and 7 are schematic cross-sectional views of an embodiment of a structure of an organic light-emitting diode;
FIG. 8 is a schematic cross-sectional view of an embodiment of a portion of a display device;
FIG. 9 is a schematic cross-sectional view of an enlarged portion of the display device of FIG. 8;
FIGS. 10A and 10B are schematic flowcharts illustrating an embodiment of a method of manufacturing a display device;
FIGS. 11 to 18 are schematic cross-sectional views of an embodiment of a portion of a display device;
FIG. 19 is a block diagram of an embodiment of an electronic device; and
FIG. 20 shows schematic diagrams of embodiments of electronic devices.

### DETAILED DESCRIPTION

Reference will now be made in detail to embodiments, illustrative embodiments of which are illustrated in the accompanying drawings, where like reference numerals refer to like elements throughout. In this regard, the present embodiments may have different forms and should not be construed as being limited to the descriptions set forth herein. Accordingly, the embodiments are merely described below, by referring to the drawing figures, to explain features of the description. As used herein, the term "and/or" includes any and all combinations of one or more of the associated listed items. Throughout the disclosure, the expression "at least one of a, b and c" indicates only a, only b, only c, both a and b, both a and c, both b and c, all of a, b, and c, or variations thereof.

As the disclosure allows for various changes and numerous embodiments, particular embodiments will be illustrated in the drawings and described in detail in the written description. Effects and features of the disclosure and methods of achieving the same will be apparent with reference to embodiments and drawings described below in detail. The disclosure may, however, be embodied in many different forms and should not be construed as being limited to the embodiments set forth herein.

The disclosure will now be described more fully with reference to the accompanying drawings, in which embodiments of the disclosure are shown. Like reference numerals in the drawings denote like elements, and thus their description will not be repeated.

In the following embodiments, while such terms as "first," "second," etc., may be used to describe various elements, such elements must not be limited to the above terms.

In the following embodiments, an expression used in the singular encompasses the expression of the plural, unless it has a clearly different meaning in the context.

In the following embodiments, it is to be understood that the terms such as "including" and "having" are intended to indicate the existence of the features, or elements disclosed in the disclosure, and are not intended to preclude the possibility that one or more other features or elements may exist or may be added.

It will be understood that when a layer, region, or element is referred to as being formed on another layer, region, or element, it may be directly or indirectly formed on the other layer, region, or element. That is, for example, intervening layers, regions, or elements may be present.

Sizes of elements in the drawings may be exaggerated or reduced for convenience of explanation. In other words, since sizes and thicknesses of components in the drawings are arbitrarily illustrated for convenience of explanation, the following disclosure is not limited thereto.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

The x-axis, the y-axis, and the z-axis are not limited to three axes on the orthogonal coordinates system, and may be interpreted in a broad sense including the same. For example, the x-axis, the y-axis, and the z-axis may be perpendicular to one another, or may represent different directions that are not perpendicular to one another.

When a certain embodiment may be implemented differently, a specific process order may be performed differently from the described order. For example, two consecutively described processes may be performed substantially at the same time or performed in an order opposite to the described order.

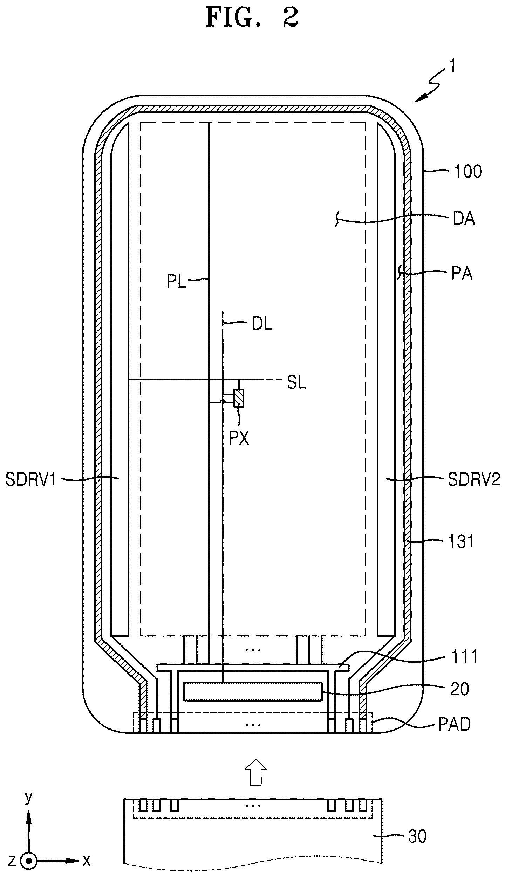

In the disclosure, the wording "in a plan view" means a plan view viewed in a direction perpendicular to a substrate 100 (refer to FIG. 2). That is, "A and B are spaced apart from each other in a plan view" means "A and B are spaced apart from each other when viewed in a direction perpendicular to the substrate 100 (refer to FIG. 2)."

In the disclosure, the wording "in a cross-sectional view" means a plan view cut in a direction perpendicular to the substrate 100 (refer to FIG. 2). That is, "A and B are spaced apart from each other in a cross-sectional view" means "A and B are spaced apart from each other in a plan view cut in a direction perpendicular to the substrate 100 (refer to FIG. 2)."

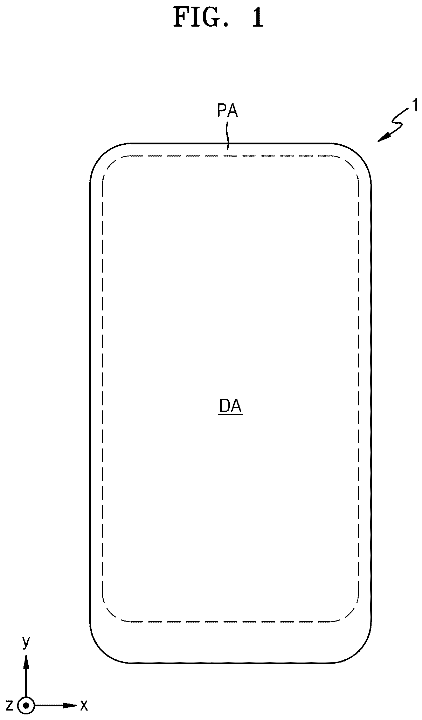

FIGS. 1 and 2 are schematic plan views of an embodiment of a display device 1.

Referring to FIG. 1, the display device 1 includes a display area DA and a peripheral area PA outside (or on the periphery of) the display area DA. Because the display device 1 includes the substrate 100 (refer to FIG. 2), the substrate 100 may be considered to include the display area DA and the peripheral area PA. In an alternative embodiment, it may be understood that the display area DA and the peripheral area PA are defined in the substrate 100.

The display area DA is a portion that displays an image, and a plurality of pixels may be disposed therein. The display area DA may have various shapes, e.g., a circular shape, an oval shape, a polygonal shape, a shape of a particular figure, or the like. In FIG. 1, the display area DA is shown to have a substantially quadrangular shape, e.g., substantially rectangular shape with rounded corners.

The peripheral area PA may be disposed outside the display area DA. The peripheral area PA may be disposed to surround at least a portion of the display area DA.

Hereinafter, an organic light-emitting display device is described in an embodiment of the display device 1. However, the display device in the disclosure is not limited thereto. In another embodiment, the display device 1 in the disclosure may be a display device such as an inorganic light-emitting display device, an inorganic electroluminescence display device, or a quantum dot light-emitting display device. In an embodiment, an emission layer of a display element provided in the display device 1 may include an organic material, an inorganic material, a quantum dot, an organic material and a quantum dot, or an inorganic material and a quantum dot, for example.

Referring to FIG. 2, the display device 1 includes the substrate 100. Various components forming the display device 1 are disposed on the substrate 100. The substrate 100 includes the display area DA and the peripheral area PA outside the display area DA. In the specification, any component being disposed in the display area DA means that the component is disposed in the display area DA of the substrate 100 or is disposed to overlap the display area DA of the substrate 100. Similarly, in the specification, any component being disposed in the peripheral area PA means that the component is disposed in the peripheral area PA of the substrate 100 or is disposed to overlap the peripheral area PA of the substrate 100.

A plurality of pixels PX may be disposed in the display area DA. Each of the pixels PX may be implemented as a light-emitting diode such as an organic light-emitting diode. Each of the pixels PX may emit red, green, blue, or white light, for example.

Pixel circuits driving the pixels PX may be connected to signal lines or voltage lines which control the on/off and brightness or the like of light-emitting diodes. In an embodiment, FIG. 2 shows a scan line SL extending in a first direction (e.g., an x-axis direction) and a data line DL extending in a second direction (e.g., a y-axis direction) as signal lines and a driving voltage line PL as a voltage line, for example.

The peripheral area PA may be a non-display area that does not display an image. The peripheral area PA may surround an entirety of the display area DA. The peripheral area PA includes outer circuits which drive the pixels PX. In an embodiment, a first scan driver SDRV1, a second scan driver SDRV2, a data driver 20, a terminal portion PAD, a driving voltage supply line 111, and a common voltage supply line 131 may be disposed in the peripheral area PA, for example.

The first scan driver SDRV1 may apply a scan signal to each of the pixel circuits driving the pixels PX via the scan line SL. The second scan driver SDRV2 may be disposed on the opposite side of the first scan driver SDRV1 with the display area DA therebetween and may be substantially parallel with the first scan driver SDRV1. Some of the pixel circuits of the pixels PX disposed in the display area DA may be electrically connected to the first scan driver SDRV1, and the remaining pixel circuits may be electrically connected to the second scan driver SDRV2.

The data driver 20 may include an integrated circuit (e.g., a driving chip) that drives the display device 1. Such an integrated circuit may be a data driving integrated circuit that generates data signals, but the disclosure is not limited thereto. The data driver 20 may include a plurality of terminals. The data driver 20 may be electrically connected to a printed circuit board 30 attached on one side of the display device 1 via the terminals. In another embodiment, the data driver 20 may also be provided on the printed circuit board 30.

The terminal portion PAD may be disposed on one side of the substrate 100. The terminal portion PAD may be exposed by not being covered by an insulating layer and may be connected to the printed circuit board 30.

A controller (not shown) may be disposed in the printed circuit board 30. The controller may generate control signals to be transmitted to the first scan driver SDRV1 and the second scan driver SDRV2. In addition, the controller may supply a driving voltage ELVDD to the driving voltage supply line 111 and may supply a common voltage ELVSS to the common voltage supply line 131. The driving voltage ELVDD may be applied to the pixel circuits of the pixels PX via the driving voltage line PL connected to the driving voltage supply line 111, and the common voltage ELVSS may be applied to an opposite electrode of a light-emitting diode connected to the common voltage supply line 131. The driving voltage supply line 111 may be provided below the display area DA to extend in the first direction (e.g., the x-axis direction). The common voltage supply line 131 may have a loop shape with one side open to partially surround the display area DA.

The controller may generate a data signal, and the generated data signal may be transmitted to the data line DL through the data driver 20. The data signal may be sequentially transmitted to the pixels PX disposed in the same column through the data lines DL extending in the second direction (e.g., the y-axis direction). In addition, the controller may generate a touch driving signal to be transmitted to each of sensor electrodes of a touch sensor layer.

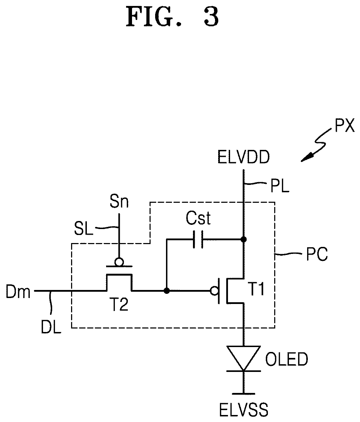

FIG. 3 is a circuit diagram schematically illustrating an embodiment of a light-emitting diode provided in the pixel PX of a display device and a pixel circuit PC connected to the light-emitting diode.

Referring to FIG. 3, the pixel circuit PC may be connected to a light-emitting element including a light-emitting diode, such as an organic light-emitting diode OLED, to implement light emission of the pixels PX. The pixel circuit PC includes a driving thin-film transistor T1, a switching thin-film transistor T2, and a storage capacitor Cst. The switching thin-film transistor T2 is connected to the scan line SL and the data line DL, and deliver, to the driving thin-film transistor T1, a data signal Dm input through the data line DL, in accordance to a scan signal Sn input through the scan line SL.

The storage capacitor Cst is connected to the switching thin-film transistor T2 and a driving voltage line PL, and stores a voltage corresponding to a difference between a voltage received from the switching thin-film transistor T2 and a driving voltage ELVDD supplied to the driving voltage line PL.

The driving thin-film transistor T1 may be connected to the driving voltage line PL and the storage capacitor Cst, and may control a driving current flowing from the driving voltage line PL to the organic light-emitting diode OLED, in accordance with a voltage value stored in the storage capacitor Cst. The organic light-emitting diode OLED may emit light having a predetermined brightness according to the driving current.

The pixel circuit PC is not limited to the number of thin-film transistors, the number of storage capacitors, and the circuit design described with reference to FIG. 3, and the numbers of thin-film transistors, the number of storage capacitors, and the circuit design may be variously changed.

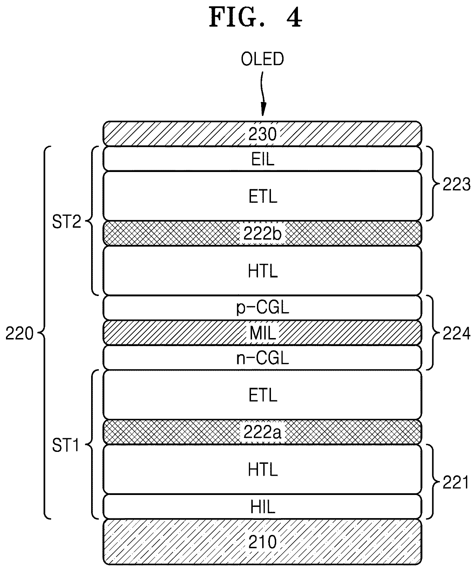

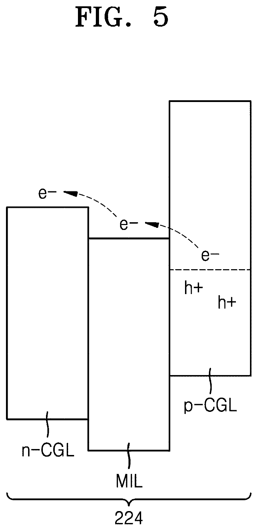

FIG. 4 is a schematic cross-sectional view of an embodiment of a structure of the organic light-emitting diode OLED, and FIG. 5 is a diagram showing an energy band diagram of a charge generation layer.

Referring to FIG. 4, the organic light-emitting diode OLED may be included in each pixel PX (refer to FIG. 2) as a light-emitting element. The organic light-emitting diode OLED may be electrically connected to the pixel circuit PC (refer to FIG. 3) of FIG. 3, and may receive power and signals through the pixel circuit PC (refer to FIG. 3) to control an emission level.

The organic light-emitting diode OLED may include a pixel electrode 210, an opposite electrode 230, and an intermediate layer 220 arranged between the pixel electrode 210 and the opposite electrode 230. The pixel electrode 210 may be patterned and provided for each organic light-emitting diode OLED, and the opposite electrode 230 may be provided in an integrated form in a plurality of organic light-emitting diodes OLED.

In an embodiment, the organic light-emitting diode OLED may have a tandem structure including a stack of two or more emitting units. In an embodiment, FIG. 4 illustrates the organic light-emitting diode OLED having a first stack ST1 and a second stack ST2, which consist of two emitting units. A first emission layer 222a and a second emission layer 222b may be respectively disposed in the first stack ST1 and the second stack ST2. A charge generation layer 224 may be disposed between the first stack ST1 and the second stack ST2. Hereinafter, each of layers stacked on the pixel electrode 210 is described in detail.

A first common layer 221 may be disposed on the pixel electrode 210. The first common layer 221 may function as a hole transport area. The first common layer 221 may include at least one layer selected from among a hole injection layer HIL, a hole transport layer HTL, an emission auxiliary layer, and an electron blocking layer. The thicknesses of the hole injection layer HIL, the hole transport layer HTL, the emission auxiliary layer, and the electron blocking layer may be provided independently of each other.

In an embodiment, the hole transport area may have a single-layered structure including a single layer including a plurality of different materials, or may have a multi-layered structure of a hole injection layer/hole transport layer, a hole injection layer/hole transport layer/emission auxiliary layer, a hole injection layer/emission auxiliary layer, a hole transport layer/emission auxiliary layer, or a hole injection layer/hole transport layer/electron blocking layer, which are sequentially stacked from the pixel electrode 210, for example.

In an embodiment, the organic light-emitting diode OLED of FIG. 4 is shown to include the hole injection layer HIL and the hole transport layer HTL as the hole transport area. The hole injection layer HIL may be disposed next (adjacent) to the pixel electrode 210, and the hole transport layer HTL may be disposed on the hole injection layer HIL.

The hole injection layer HIL may function to facilitate hole injection and may include any one or more selected from a group consisting of hexaazatriphenylene-hexacarbonitrile ("HAT-CN"), copper phthalocyanine ("CuPc"), poly(3,4)-ethylenedioxythiophene ("PEDOT"), and N, N-dinaphthyl-N, N'-diphenylbenzidine ("NPD"), but the disclosure is not limited thereto.

The hole transport layer HTL may include a triphenylamine derivative having relatively high hole mobility and relatively excellent stability, such as tris(4-carbazoyl-9-ylphenyl)amine ("TCTA"), N, N'-diphenyl-N,N'-bis(3-methylphenyl)-1,1'-bi-phenyl-4,4'-diamine ("TPD"), or N,N'-di(naphthalen-1-yl)-N,N'-diphenyl-benzidine ("NPB"), as a host of the hole transport layer HTL. FIG. 4 shows that the hole transport layer HTL is a single layer, but the hole transport layer HTL may also be provided in a multi-layered structure. The hole transport layer HTL may have a multi-layered structure of two or more layers including different materials from among the materials described above. In an embodiment, the hole transport layer HTL may be provided as double layers respectively including NPB and TCTA, for example.

The first emission layer 222a may be disposed on the first common layer 221. The first emission layer 222a may include an organic material that emits one of red, blue, and green light. In an embodiment, when the first emission layer 222a emits red light, the first emission layer 222a may be formed by, e.g., a red dopant in a predetermined host material, for example. In an alternative embodiment, when the first emission layer 222a emits green light, the first emission layer 222a may be formed by, e.g., a green dopant in a predetermined host material. In an alternative embodiment, when the first emission layer 222a emits blue light, the first emission layer 222a may be formed by, e.g., a blue dopant in a predetermined host material.

An electron transport layer ETL may be disposed on the first emission layer 222a. The electron transport layer ETL disposed on the first emission layer 222a may perform the same function as an electron transport layer ETL included in a second common layer 223.

The charge generation layer 224 may be disposed on the electron transport layer ETL. The charge generation layer 224 may be disposed between the first stack ST1 and the second stack ST2. In FIG. 4, the charge generation layer 224 may be disposed between the electron transport layer ETL and the hole transport layer HTL.

In an embodiment, the charge generation layer 224 may include an n-type charge generation layer n-CGL which supplies an electron to the first stack ST1, and a p-type charge generation layer p-CGL which supplies a hole to the second stack ST2. In addition, a metal intermediate layer MIL may be included between the n-type charge generation layer n-CGL and the p-type charge generation layer p-CGL.

The n-type charge generation layer n-CGL may include an n-type dopant material and an n-type host material. In an embodiment, a volume ratio of the n-type host material and the n-type dopant material may be about 99:1 to about 90:10. The n-type dopant material may be a metal dopant, and the n-type host material may be an organic material, more particularly, an organic semiconductor material.

The n-type dopant material may be a metal of Group 1 or Group 2 on the periodic table, an organic material capable of injecting electrons, or any combinations thereof. In an embodiment, the n-type dopant material may be any one of an alkali metal or an alkaline earth metal, for example. That is, the n-type charge generation layer n-CGL may include an alkali metal such as lithium (Li), sodium (Na), potassium (K), or cesium (Cs), or an organic material doped with an alkaline earth metal such as magnesium (Mg), strontium (Sr), barium (Ba), radium (Ra), or ytterbium (Yb), but the disclosure is not limited thereto. In an alternative embodiment, the n-type dopant material may include rare earth elements of the lanthanide series. In an embodiment, the n-type dopant material may be any one of dysprosium (Dy), europium (Eu), and samarium (Sm), for example. As the n-type dopant material, a metal having a work function less than -3 electron-volts (eV) may be used.

The n-type host material may include a material capable of transferring electrons, e.g., any one or more of tris(8-hydroxyquinolino)aluminum (Alq3), 8-hydroxyquinolinolato-lithium ("Liq"), 2-(4-biphenylyl)-5-(4-tert-butylphenyl)-1,3,4oxadiazole ("PBD"), 3-(4-biphenyl)4-phenyl-5-tert-butylphenyl-1,2,4-triazole ("TAZ"), spiro-PBD, bis(2-methyl-8-quinolinolate)-4-(phenylphenolato)aluminium ("BAlq"), SAlq, 2,2',2-(1,3,5-benzinetriyl)-tris(1-phenyl-1-H-benzimidazole ("TPBi"), oxadiazole, triazole, phenanthroline, benzoxazole, or benzothiazole, but the disclosure is not limited thereto.

The p-type charge generation layer p-CGL may include a p-type dopant material and a p-type host material. In an embodiment, a volume ratio of the p-type host material and the p-type dopant material may be about 99:1 to about 80:20. The p-type host material and the p-type dopant material may be organic materials, and more particularly, the p-type host material may be a first organic semiconductor material, and the p-type dopant material may be a second organic semiconductor material or a metal material.

The p-type dopant material may include a metal oxide, an organic material such as tetrafluoro-tetracyanoquinodimethane ("F4-TCNQ"), HAT-CN, hexaazatriphenylene, or a metal material such as V₂O₅, MoOₓ, WO₃, or the like, but the disclosure is not limited thereto. The p-type host material may include a material capable of transferring holes, e.g., a material include any one or more of N,N-dinaphthyl-N,N'-diphenyl benzidine)(N,N'-bis(naphthalene-1-yl)-N,N'-bis(phenyl)-2,2'-dimethylbenzidine ("NPD"), N,N'-bis-(3-methylphenyl)-N,N'-bis-(phenyl)-benzidine ("TPD"), and 4,4',4-Tris(N-3-methylphenyl-N-phenyl-amino)-triphenylamine ("MTDATA"), but the disclosure is not limited thereto.

The n-type charge generation layer n-CGL and the p-type charge generation layer p-CGL may each be formed to a thickness of about 1 angstroms (Å) to about 200 Å. When each of the thickness of the n-type charge generation layer n-CGL and the p-type charge generation layer p-CGL satisfies the above-described range, satisfactory charge transport characteristics may be obtained without a substantial increase in driving voltage.

As such, charge accumulation may occur at the interface between the n-type charge generation layer n-CGL and the p-type charge generation layer p-CGL due to a relatively high energy barrier difference formed between the lowest unoccupied molecular orbitals level ("LUMO") energy level of the n-type charge generation layer n-CGL and the highest occupied molecular orbitals level ("HOMO") energy level of the p-type charge generation layer p-CGL, as shown in FIG. 5. An accumulated charge e- may cause deterioration at the interface between the n-type charge generation layer n-CGL and the p-type charge generation layer p-CGL, thereby leading to problems such as an increased driving voltage and reduced lifespan of the organic light-emitting diode OLED.

Accordingly, in the organic light-emitting diode OLED in an embodiment, the metal intermediate layer MIL may be disposed between the n-type charge generation layer n-CGL and the p-type charge generation layer p-CGL. Charge accumulation at the interface between the n-type charge generation layer n-CGL and the p-type charge generation layer p-CGL may be effectively improved by facilitating the movement of charges e- by forming stepwise energy levels by inserting the metal intermediate layer MIL between the n-type charge generation layer n-CGL and the p-type charge generation layer p-CGL. Furthermore, through this way, the cause of deterioration inside the organic light-emitting diode OLED may be reduced, and effects of reduced driving voltage and increased lifespan may be expected.

The LUMO energy level of the metal intermediate layer MIL may be a value between the LUMP energy level of the n-type charge generation layer n-CGL and the HOMO energy level of the p-type charge generation layer p-CGL. An absolute value (not a negative value itself) of an energy level may gradually decrease in an order of the HOMO energy level of the p-type charge generation layer p-CGL, the LUMO energy level of the metal intermediate layer MIL, and the LUMO energy level of the n-type charge generation layer n-CGL.

In an embodiment, the metal intermediate layer MIL may include a metal having a work function of about -6.0 eV to about -3.5 eV. In an embodiment, the metal intermediate layer MIL may include at least one of bismuth (Bi), magnesium (Mg), and zinc (Zn). In addition, the metal intermediate layer MIL may include an alkaline earth metal including Mg, a transition metal including Zn, or a post-transition metal including Bi. In an embodiment, the work function of Bi may be about -4.34 eV, the work function of Mg may be about -3.66 eV, and the work function of Zn may be about -3.63 eV to about -4.9 eV, for example. Accordingly, stepwise energy levels may be formed between the LUMO energy level of the n-type charge generation layer n-CGL and the HOMO energy level of the p-type charge generation layer p-CGL.

The metal intermediate layer MIL including Bi, Mg, or Zn may mean that a metal layer including or consisting of the above metals is substantially provided, instead of including the above metals in any organic material as dopants or additives.

The metal intermediate layer MIL may be formed to a thickness of about 1 Å to about 100 Å. The metal intermediate layer MIL may be formed to a thickness that is less than the thicknesses of n-type charge generation layer n-CGL and the p-type charge generation layer p-CGL. When the metal intermediate layer MIL is formed to a thickness that is less than 1 Å, the metal intermediate layer MIL may not function properly, and when the metal intermediate layer MIL is formed to a thickness that exceeds 100 Å, an amount of light absorbed by the metal intermediate layer MIL may increase, which may reduce an amount of light emitted through the organic light-emitting diode OLED. As described above, because the metal intermediate layer MIL includes a reflective metal material, when the metal intermediate layer MIL is formed to have a thickness that exceeds 100 Å, the emission power of the organic light-emitting diode OLED may be reduced.

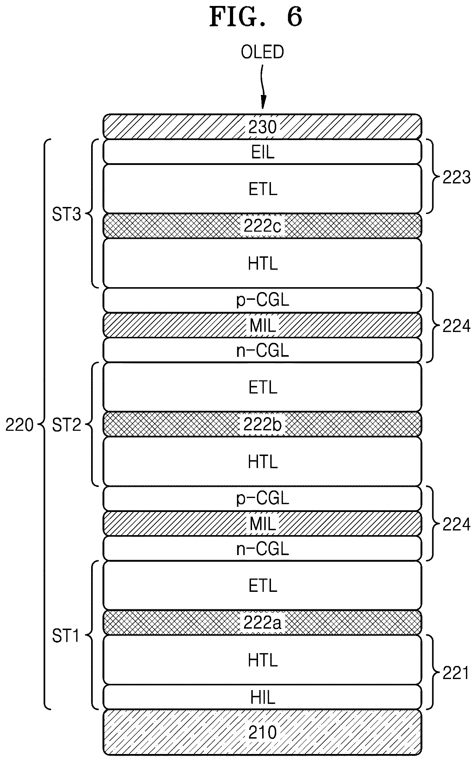

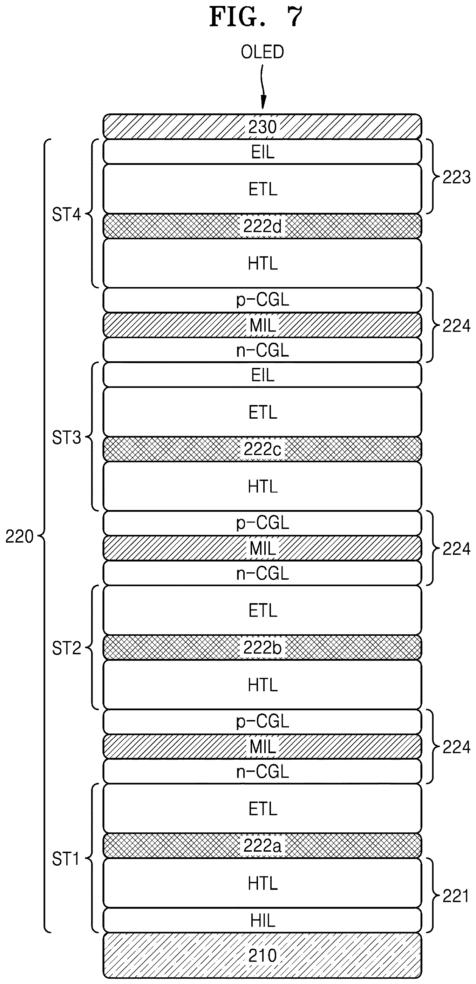

FIGS. 6 and 7 are schematic cross-sectional views of an embodiment of a structure of the organic light-emitting diode OLED.

Referring to FIG. 6, the organic light-emitting diode OLED may have a tandem structure including a stack of three or more emitting units. In an embodiment, FIG. 6 illustrates the organic light-emitting diode OLED having a first stack ST1, a second stack ST2, and a third stack ST3, which consist of three emitting units. The first emission layer 222a to a third emission layer 222c may be respectively disposed in the first stack ST1 to the third stack ST3. In addition, the charge generation layer 224 may be disposed between the first stack ST1 and the second stack ST2 and between the second stack ST2 and the third stack ST3.

Referring to FIG. 7, the organic light-emitting diode OLED may have a tandem structure including a stack of four or more emitting units. In an embodiment, FIG. 7 illustrates the organic light-emitting diode OLED having a first stack ST1, a second stack ST2, a third stack ST3, and a fourth stack ST4, which consist of four emitting units. The first emission layer 222a to a fourth emission layer 222d may be respectively disposed in the first stack ST1 to the fourth stack ST4. In addition, the charge generation layer 224 may be disposed between the first stack ST1 and the second stack ST2, between the second stack ST2 and the third stack ST3, and between the third stack ST3 and the fourth stack ST4.

In the stacked structure of the intermediate layer 220 disposed between the pixel electrode 210 and the opposite electrode 230, layers indicating the same reference numerals may mean the same layers as in FIG. 3 described above. Hereinafter, redundant descriptions are omitted, and differences from FIG. 3 are mainly described.

Referring to FIG. 6 or 7, the organic light-emitting diode OLED may have a tandem structure including a stack of m or more emitting units. (m is an integer of 2 or more) m-1 charge generation layers 224 may be arranged between respective stacks.

The charge generation layer 224 may include the n-type charge generation layer n-CGL, the p-type charge generation layer p-CGL, and the metal intermediate layer MIL between the n-type charge generation layer n-CGL and the p-type charge generation layer p-CGL. The charge generation layer 224 must include the n-type charge generation layer n-CGL and the p-type charge generation layer p-CGL, and the metal intermediate layer MIL may be optionally provided. In FIGS. 6 and 7, all charge generation layers 224 are shown to include the metal intermediate layer MIL, but the disclosure is not limited thereto. In an embodiment, at least one of the m-1 charge generation layers 224 may include the metal intermediate layer MIL.

The organic light-emitting diode OLED of FIG. 6 may emit red, blue, green, or white light. The organic light-emitting diode OLED includes the first emission layer 222a to the third emission layer 222c, and the first emission layer 222a to the third emission layer 222c may each include an organic material that emits one of red, blue, and green light. The first emission layer 222a to the third emission layer 222c may emit light of the same wavelength, or at least some of the first emission layer 222a to the third emission layer 222c may emit light of different wavelengths. In an embodiment, the first emission layer 222a to the third emission layer 222c may all emit blue light, for example. In an alternative embodiment, the first emission layer 222a and the second emission layer 222b may emit blue light, and the third emission layer 222c may emit green light.

Similarly, the organic light-emitting diode OLED of FIG. 7 may emit red, blue, green, or white light. The organic light-emitting diode OLED includes the first emission layer 222a to the fourth emission layer 222d, and the first emission layer 222a to the fourth emission layer 222d may each include an organic material that emits one of red, blue, and green light. The first emission layer 222a to the fourth emission layer 222d may emit light of the same wavelength, or at least some of the first emission layer 222a to the fourth emission layer 222d may emit light of different wavelengths. In an embodiment, the first emission layer 222a to the fourth emission layer 222d may all emit blue light, for example. In an alternative embodiment, the first emission layer 222a to the third emission layer 222c may emit blue light, and the fourth emission layer 222d may emit green light.

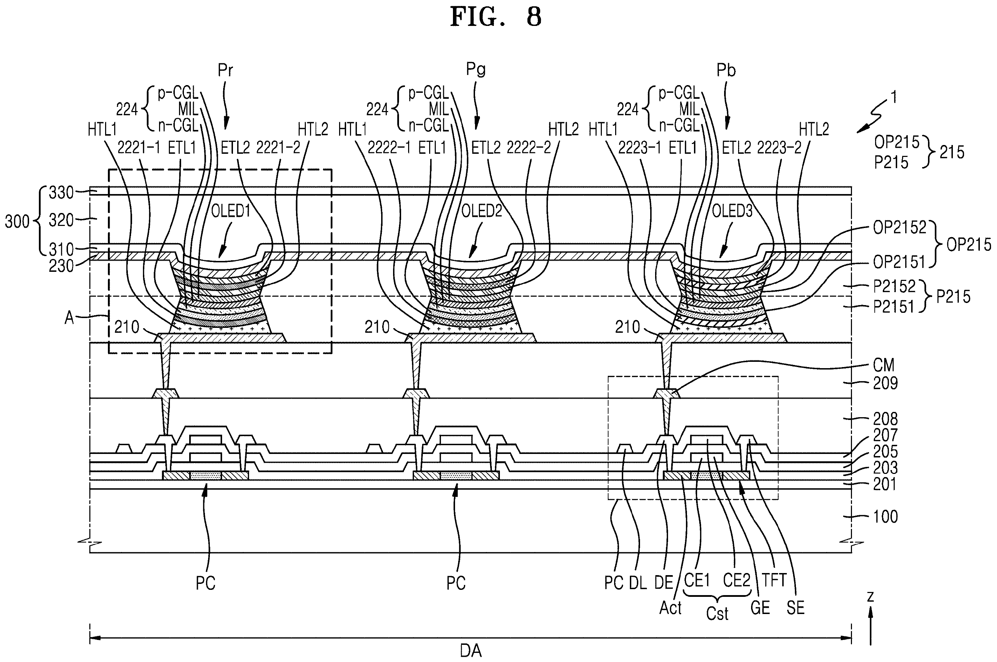

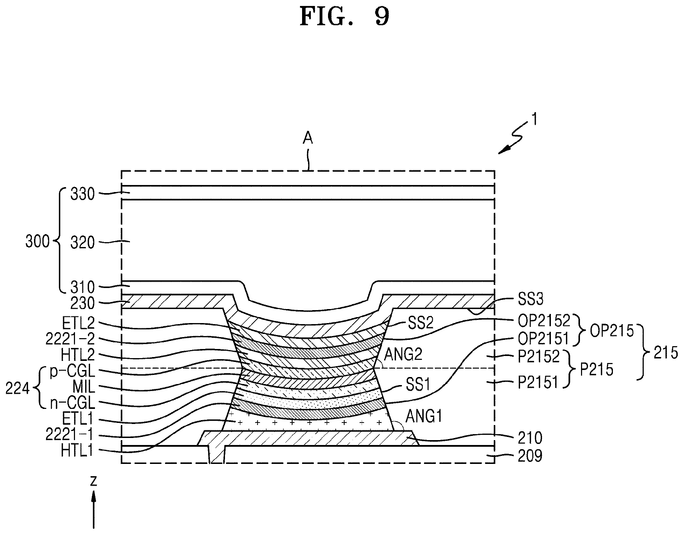

FIG. 8 is a schematic cross-sectional view of an embodiment of a portion of the display device 1, and FIG. 9 is a schematic cross-sectional view of an enlarged portion of the display device 1 of FIG. 8.

In particular, FIG. 9 is an enlarged view of the cross-sectional view of the display device 1 for a region A of FIG. 8.

Referring to FIGS. 8 and 9, first to third pixels Pr, Pg, and Pb are disposed above the substrate 100. The first to third pixels Pr, Pg, and Pb may respectively include first to third organic light-emitting diodes OLED1, OLED2, and OLED3 and the pixel circuit PC, and each of the first to third organic light-emitting diodes OLED1, OLED2, and OLED3 may be electrically connected to the pixel circuit PC, so that light emission thereof may be controlled. In the following description, the pixel circuit PC included in each of the first to third pixels Pr, Pg, and Pb has the same structure, and a stacked structure is described mainly with respect to one pixel.

First, the substrate 100 may include a glass material or a polymer resin. In an embodiment, the substrate 100 may include a plurality of sub-layers. The plurality of sub-layers may have a structure in which organic layers and inorganic layers are alternately stacked. When the substrate 100 includes a polymer resin, the substrate 100 may include polyethersulfone, polyacrylate, polyetherimide, polyethylene naphthalate, polyethylene terephthalate, polyphenylene sulfide, polyarylate, polyimide, polycarbonate, or cellulose acetate propionate.

A buffer layer 201 may be formed on the substrate 100 to prevent impurities from penetrating into a semiconductor layer Act of a thin-film transistor TFT. The buffer layer 201 may include an inorganic insulating material such assilicon nitride, silicon oxynitride, and silicon oxide, and may be a single layer or a multilayer, each including the above-described inorganic insulating material.

The pixel circuit PC may be disposed above the substrate 100. In particular, the pixel circuit PC may be disposed on the buffer layer 201. The pixel circuit PC may include the thin-film transistor TFT and a storage capacitor Cst. The thin-film transistor TFT may include the semiconductor layer Act, a gate electrode GE, a source electrode SE, and a drain electrode DE. A plurality of pixel circuits PC may be provided, and the plurality of pixel circuits PC may be spaced apart from each other. The plurality of pixel circuits PC may be disposed to correspond to the first to third pixels Pr, Pg, and Pb, respectively.

Although not shown in FIG. 5, a data line DL of the pixel circuit PC is electrically connected to a switching thin-film transistor included in the pixel circuit PC. In an embodiment, a top-gate type in which the gate electrode GE is disposed above the semiconductor layer Act with a gate insulating layer 203 between the gate electrode GE and the semiconductor layer Act is shown, but in another embodiment, the thin-film transistor TFT may be a bottom-gate type.

The semiconductor layer Act may include an oxide semiconductor. In an alternative embodiment, the semiconductor layer Act may include amorphous silicon, polysilicon, or an organic semiconductor.

The gate electrode GE may include a low-resistance metal material. The gate electrode GE may include a conductive material including molybdenum (Mo), aluminum (Al), copper (Cu), titanium (Ti), or the like, and may include a multi-layer or a single layer, each including the material stated above.

The gate insulating layer 203 between the semiconductor layer Act and the gate electrode GE may include an inorganic insulating material such as silicon oxide, silicon nitride, silicon oxynitride, aluminum oxide, titanium oxide, tantalum oxide, hafnium oxide, or the like. The gate insulating layer 203 may be a single layer or a multi-layer, each including the above-mentioned material.

The source electrode SE and the drain electrode DE may be disposed in the same layer as the data line DL, and may include the same material as that of the data line DL. The source electrode SE, the drain electrode DE, and the data line DL may each include a material with good conductivity. Each of the source electrode SE and the drain electrode DE may include a conductive material including Mo, Al, Cu, Ti, or the like, and may include a multi-layer or a single layer, each including the above material. In an embodiment, the source electrode SE, the drain electrode DE, and the data line DL may each be formed as a multi-layer of Ti/Al/Ti, for example.

The storage capacitor Cst may include a first electrode CE1 and a second electrode CE2, which overlap each other with a first inter-insulating layer 205 therebetween. The storage capacitor Cst may overlap the thin-film transistor TFT. In this regard, FIG. 5 shows that the gate electrode GE of the thin-film transistor TFT is the first electrode CE1 of the storage capacitor Cst. In another embodiment, the storage capacitor Cst may not overlap the thin-film transistor TFT. The storage capacitor Cst may be covered by a second inter-insulating layer 207. The second electrode CE2 of the storage capacitor Cst may include a conductive material including Mo, Al, Cu, Ti, or the like, and may include a multi-layer or a single layer, each including the above material.

The first inter-insulating layer 205 and the second inter-insulating layer 207 may each include an inorganic insulating material such as silicon oxide, silicon nitride, silicon oxynitride, aluminum oxide, titanium oxide, tantalum oxide, hafnium oxide, or the like. The first inter-insulating layer 205 and the second inter-insulating layer 207 may each be a single layer or a multi-layer, each including the above-mentioned material.

The pixel circuit PC including the thin-film transistor TFT and the storage capacitor Cst may be covered with a first planarization insulating layer 208. An upper surface of the first planarization insulating layer 208 may be substantially flat.

Although not shown in the drawing, a third inter-insulating layer (not shown) may be further disposed below the first planarization insulating layer 208. The third inter-insulating layer may include an inorganic insulating material such as silicon oxide, silicon nitride, and silicon oxynitride.

The pixel electrode 210 may be disposed on the pixel circuit PC. The pixel circuit PC may be electrically connected to the pixel electrode 210. In an embodiment, as shown in FIG. 5, a contact metal layer CM may be disposed between the thin-film transistor TFT and the pixel electrode 210, for example. The contact metal layer CM may contact the thin-film transistor TFT through a contact hole defined in the first planarization insulating layer 208, and the pixel electrode 210 may contact the contact metal layer CM through a contact hole defined in a second planarization insulating layer 209 on the contact metal layer CM. The contact metal layer CM may include a conductive material including Mo, Al, Cu, Ti, or the like, and may be a multi-layer or a single layer, each including the above material. In an embodiment, the contact metal layer CM may include a multi-layer of Ti/Al/Ti.

The first planarization insulating layer 208 and the second planarization insulating layer 209 may each include a general commercial polymer such as poly(methyl methacrylate) ("PMMA") or polystyrene ("PS"), a polymer derivative having a phenol group, and an organic insulating material, such as an acrylic polymer, an imide polymer, an aryl ether polymer, an amide polymer, a fluorine polymer, a p-xylene polymer, a vinyl alcohol polymer, and any combinations thereof. In an embodiment, the first planarization insulating layer 208 and the second planarization insulating layer 209 may each include polyimide.

Referring to FIGS. 8 and 9 together, the first to third organic light-emitting diodes OLED1, OLED2, and OLED3 may be disposed on the second planarization insulating layer 209. The first organic light-emitting diode OLED1 may include the pixel electrode 210, a first hole transport layer HTL1, a first-first emission layer 2221-1, a first electron transport layer ETL1, a charge generation layer 224, a second hole transport layer HTL2, a first-second emission layer 2221-2, a second electron transport layer ETL2, and the opposite electrode 230, which are sequentially stacked in a direction away from the substrate 100 (e.g., a z direction). The second organic light-emitting diode OLED2 may include the pixel electrode 210, the first hole transport layer HTL1, a second-first emission layer 2222-1, the first electron transport layer ETL1, the charge generation layer 224, the second hole transport layer HTL2, a second-second emission layer 2222-2, the second electron transport layer ETL2, and the opposite electrode 230, which are sequentially stacked in the direction away from the substrate 100 (e.g., the z direction). The third organic light-emitting diode OLED3 may include the pixel electrode 210, the first hole transport layer HTL1, a third-first emission layer 2223-1, the first electron transport layer ETL1, the charge generation layer 224, the second hole transport layer HTL2, a third-second emission layer 2223-2, the second electron transport layer ETL2, and the opposite electrode 230, which are sequentially stacked in the direction away from the substrate 100 (e.g., the z direction).

The pixel electrode 210, the charge generation layer 224, and the opposite electrode 230, which are described with reference to FIG. 8, may correspond to the pixel electrode 210 (refer to FIG. 4), the charge generation layer 224 (refer to FIG. 4), and the opposite electrode 230 (refer to FIG. 4), which are described with reference to FIG. 4, respectively. The first hole transport layer HTL1 and the first electron transport layer ETL1, which are described with reference to FIG. 8, may correspond to the hole transport layer HTL (refer to FIG. 4) and the electron transport layer ETL (refer to FIG. 4) of the first stack ST1 (refer to FIG. 4), which are described with reference to FIG. 4, respectively. The second hole transport layer HTL2 and the second electron transport layer ETL2, which are described with reference to FIG. 8, may correspond to the hole transport layer HTL (refer to FIG. 4) and the electron transport layer ETL (refer to FIG. 4) of the second stack ST2 (refer to FIG. 4), which are described with reference to FIG. 4, respectively. The first-first emission layer 2221-1, the second-first emission layer 2222-1, and the third-first emission layer 2223-1, which are described with reference to FIG. 8, may correspond to the first emission layer 222a (refer to FIG. 4) of the first stack ST1 (refer to FIG. 4), which is described with reference to FIG. 4. The first-second emission layer 2221-2, the second-second emission layer 2222-2, and the third-second emission layer 2223-2, which are described with reference to FIG. 8, may correspond to the second emission layer 222b (refer to FIG. 4) of the second stack ST2 (refer to FIG. 4), which is described with reference to FIG. 4.

The pixel electrode 210 may include a conductive oxide such as indium tin oxide ("ITO"), indium zinc oxide ("IZO"), zinc oxide (ZnO), indium oxide (In₂O₃), indium gallium oxide ("IGO"), or aluminum zinc oxide ("AZO"). In another embodiment, the pixel electrode 210 may include a reflective film including silver (Ag), Mg, Al, platinum (Pt), palladium (Pd), gold (Au), nickel (Ni), neodymium (Nd), iridium (Ir), chromium (Cr), or any combinations thereof. In another embodiment, the pixel electrode 210 may further include a film including ITO, IZO, ZnO, or In₂O₃above and/or below the reflective film described above.

A bank layer 215 may include a bank portion P215 and define a bank opening OP215. The bank portion P215 may be disposed on the pixel electrode 210. The bank opening OP215 may be disposed in the bank portion P215 and may penetrate the bank portion P215. The bank opening OP215 may expose at least a portion of the pixel electrode 210 from the bank portion P215. The bank portion P215 may cover an edge of the pixel electrode 210. The bank portion P215 may include an organic insulating material. In an alternative embodiment, the bank portion P215 may include an inorganic insulating material such as silicon nitride, silicon oxynitride, or silicon oxide. In an alternative embodiment, the bank portion P215 may include an organic insulating material and an inorganic insulating material.

The bank portion P215 may include a first bank portion P2151 and a second bank portion P2152. The second bank portion P2152 may be disposed on the first bank portion P2151. The first bank portion P2151 may be disposed on the second planarization insulating layer 209 to cover a portion of the pixel electrode 210, and the second bank portion P2152 may cover the first bank portion P2151.

The bank opening OP215 may include a first bank opening OP2151 and a second bank opening OP2152. The first bank opening OP2151 may be defined in the first bank portion P2151, and the second bank opening OP2152 may be defined in the second bank portion P2152. That is, the second bank opening OP2152 may be defined on the first bank opening OP2151. The first bank opening OP2151 and the second bank opening OP2152 may overlap each other. The first bank opening OP2151 and the second bank opening OP2152 may communicate with each other. The pixel electrode 210 may be exposed from the first bank portion P2151 through the first bank opening OP2151. The pixel electrode 210 may be exposed from the second bank portion P2152 through the second bank opening OP2152.

The first bank portion P2151 may be reverse-tapered with respect to the substrate 100. An angle ANG1 between the substrate 100 and a side surface SS1 of the first bank portion P2151, which defines the first bank opening OP2151, may be an obtuse angle. At this time, because the substrate 100 and the pixel electrode 210 are disposed in parallel to each other, the angle ANG1 between the side surface SS1 of the first bank portion P2151 and the substrate 100 may be defined as an angle between the side surface SS1 of the first bank portion P2151 and an upper surface of the pixel electrode 210. Here, the upper surface of the pixel electrode 210 means an upper surface of the pixel electrode 210, which contacts the first bank portion P2151. In a cross-sectional view, the angle ANG1 between the first bank portion P2151 and the substrate 100 may be 90 degrees or more and 130 degrees or less.

The second bank portion P2152 may be tapered with respect to the substrate 100. An angle ANG2 between the substrate 100 and a side surface SS2 of the second bank portion P2152, which defines the second bank opening OP2152, may be an acute angle. At this time, because the substrate 100 and the pixel electrode 210 are disposed in parallel to each other, the angle ANG2 between the side surface SS2 of the second bank portion P2152 and the substrate 100 may be defined as an angle between the side surface SS2 of the second bank portion P2152 and the upper surface of the pixel electrode 210. Here, the upper surface of the pixel electrode 210 means an upper surface of the pixel electrode 210, which contacts the first bank portion P2151.

In a cross-sectional view, the angle ANG2 between the second bank portion P2152 and the substrate 100 may be 60 degrees or more and 70 degrees or less.

In the first organic light-emitting diode OLED1, the first-first emission layer 2221-1 may be accommodated in the bank opening OP215 (particularly, the first bank opening OP2151) and may be disposed above the pixel electrode 210. The charge generation layer 224 may be accommodated in the bank opening OP215 (particularly, the first bank opening OP2151) and may be disposed above the first-first emission layer 2221-1. The first-second emission layer 2221-2 may be accommodated in the bank opening OP215 (particularly, the second bank opening OP2152) and may be disposed above the charge generation layer 224. The opposite electrode 230 may cover the bank portion P215 and may be disposed above the first-second emission layer 2221-2. The first hole transport layer HTL1 may be disposed between the pixel electrode 210 and the first-first emission layer 2221-1. The first electron transport layer ETL1 may be disposed between the first-first emission layer 2221-1 and the charge generation layer 224. The second hole transport layer HTL2 may be disposed between the charge generation layer 224 and the first-second emission layer 2221-2. The second electron transport layer ETL2 may be disposed between the first-second emission layer 2221-2 and the opposite electrode 230.

In the second organic light-emitting diode OLED2, the second-first emission layer 2222-1 may be accommodated in the bank opening OP215 (particularly, the first bank opening OP2151) and may be disposed above the pixel electrode 210. The charge generation layer 224 may be accommodated in the bank opening OP215 (particularly, the first bank opening OP2151) and may be disposed above the second-first emission layer 2222-1. The second-second emission layer 2222-2 may be accommodated in the bank opening OP215 (particularly, the second bank opening OP2152) and may be disposed above the charge generation layer 224. The opposite electrode 230 may cover the bank portion P215 and may be disposed above the second-second emission layer 2222-2. The first hole transport layer HTL1 may be disposed between the pixel electrode 210 and the second-first emission layer 2222-1. The first electron transport layer ETL1 may be disposed between the second-first emission layer 2222-1 and the charge generation layer 224. The second hole transport layer HTL2 may be disposed between the charge generation layer 224 and the second-second emission layer 2222-2. The second electron transport layer ETL2 may be disposed between the second-second emission layer 2222-2 and the opposite electrode 230.

In the third organic light-emitting diode OLED3, the third-first emission layer 2223-1 may be accommodated in the bank opening OP215 (particularly, the first bank opening OP2151) and may be disposed above the pixel electrode 210. The charge generation layer 224 may be accommodated in the bank opening OP215 (particularly, the first bank opening OP2151) and may be disposed above the third-first emission layer 2223-1. The third-second emission layer 2223-2 may be accommodated in the bank opening OP215 (particularly, the second bank opening OP2152) and may be disposed above the charge generation layer 224. The opposite electrode 230 may cover the bank portion P215 and may be disposed above the third-second emission layer 2223-2. The first hole transport layer HTL1 may be disposed between the pixel electrode 210 and the third-first emission layer 2223-1. The first electron transport layer ETL1 may be disposed between the third-first emission layer 2223-1 and the charge generation layer 224. The second hole transport layer HTL2 may be disposed between the charge generation layer 224 and the third-second emission layer 2223-2. The second electron transport layer ETL2 may be disposed between the third-second emission layer 2223-2 and the opposite electrode 230.

The first hole transport layers HTL1 of the first organic light-emitting diode OLED1, the second organic light-emitting diode OLED2, and the third organic light-emitting diode OLED3 may include the same material and may be disposed in the same layer to be spaced apart from each other. The first electron transport layers ETL1 of the first organic light-emitting diode OLED1, the second organic light-emitting diode OLED2, and the third organic light-emitting diode OLED3 may include the same material and may be disposed in the same layer to be spaced apart from each other. The charge generation layers 224 of the first organic light-emitting diode OLED1, the second organic light-emitting diode OLED2, and the third organic light-emitting diode OLED3 may include the same material and may be disposed in the same layer to be spaced apart from each other. The second hole transport layers HTL2 of the first organic light-emitting diode OLED1, the second organic light-emitting diode OLED2, and the third organic light-emitting diode OLED3 may include the same material and may be disposed in the same layer to be spaced apart from each other. The second electron transport layers ETL2 of the first organic light-emitting diode OLED1, the second organic light-emitting diode OLED2, and the third organic light-emitting diode OLED3 may include the same material and may be disposed in the same layer to be spaced apart from each other.

The first-first emission layer 2221-1, the second-first emission layer 2222-1, and the third-first emission layer 2223-1 may be disposed in the same layer to be spaced apart from each other. The first-first emission layer 2221-1, the second-first emission layer 2222-1, and the third-first emission layer 2223-1 may emit different light. In an embodiment, the first-first emission layer 2221-1 may emit red light, the second-first emission layer 2222-1 may emit green light, and the third-first emission layer 2223-1 may emit blue light, for example.

The first-second emission layer 2221-2, the second-second emission layer 2222-2, and the third-second emission layer 2223-2 may be disposed in the same layer to be spaced apart from each other. The first-second emission layer 2221-2, the second-second emission layer 2222-2, and the third-second emission layer 2223-2 may emit different light. The first-second emission layer 2221-2 may emit the same light as the first-first emission layer 2221-1, the second-second emission layer 2222-2 may emit the same light as the second-first emission layer 2222-1, and the third-second emission layer 2223-2 may emit the same light as the third-first emission layer 2223-1. In an embodiment, the first-second emission layer 2221-2 may emit red light, the second-second emission layer 2222-2 may emit green light, and the third-second emission layer 2223-2 may emit blue light, for example.

That is, in the first to third organic light-emitting diodes OLED1, OLED2, and OLED3, the pixel electrode 210, the first hole transport layer HTL1, the first electron transport layer ETL1, the charge generation layer 224, the second hole transport layer HTL2, and the second electron transport layer ETL2 may be patterned and provided for each pixel. In the first to third organic light-emitting diodes OLED1, OLED2, and OLED3, the first-first emission layer 2221-1, the first-second emission layer 2221-2, the second-first emission layer 2222-1, the second-second emission layer 2222-2, the third-first emission layer 2223-1, and the third-second emission layer 2223-2 may be patterned and provided for each pixel. In the first to third organic light-emitting diodes OLED1, OLED2, and OLED3, the opposite electrode 230 may be integrally provided.

The opposite electrode 230 may be integrally provided in the display area DA. Because the second bank portion P2152 is provided in a tapered structure, the opposite electrode 230 may be provided as one common layer across the first to third organic light-emitting diodes OLED1, OLED2, and OLED3 without being disconnected. That is, a short-circuit phenomenon of the opposite electrode 230 may be reduced.

Each of the first hole transport layer HTL1, the first electron transport layer ETL1, and the charge generation layer 224 contacts the side surface SS1 of the first bank portion P2151, but may be spaced apart from the side surface SS2 of the second bank portion P2152. The second hole transport layer HTL2 and the second electron transport layer ETL2 contact the side surface SS2 of the second bank portion P2152, but may be spaced apart from the side surface SS1 of the first bank portion P2151. Each of the first-first emission layer 2221-1, the second-first emission layer 2222-1, and the third-first emission layer 2223-1 contacts the side surface SS1 of the first bank portion P2151, but may be spaced apart from the side surface SS2 of the second bank portion P2152. Each of the first-second emission layer 2221-2, the second-second emission layer 2222-2, and the third-second emission layer 2223-2 contacts the side surface SS2 of the second bank portion P2152, but may be spaced apart from the side surface SS1 of the first bank portion P2151.

The charge generation layer 224 may include the n-type charge generation layer n-CGL, the metal intermediate layer MIL, and the p-type charge generation layer p-CGL. The metal intermediate layer MIL may be disposed on the n-type charge generation layer n-CGL, and the p-type charge generation layer p-CGL may be disposed on the metal intermediate layer MIL. The n-type charge generation layer n-CGL, the metal intermediate layer MIL, and the p-type charge generation layer p-CGL may respectively correspond to the n-type charge generation layer n-CGL (refer to FIG. 4), the metal intermediate layer MIL (refer to FIG. 4), and the p-type charge generation layer p-CGL (refer to FIG. 4), which are described with respect to FIG. 4.

The n-type charge generation layer n-CGL, the metal intermediate layer MIL, and the p-type charge generation layer p-CGL may each contact side surfaces of the bank layer 215. In particular, the n-type charge generation layer n-CGL, the metal intermediate layer MIL, and the p-type charge generation layer p-CGL may each contact the side surface SS1 of the first bank portion P2151.

The first electron transport layer ETL1 and the second hole transport layer HTL2 may be separated by the metal intermediate layer MIL. Accordingly, a phenomenon in which a solvent of the second hole transport layer HTL2 penetrates into the first electron transport layer ETL1 may be reduced by the metal intermediate layer MIL.

In addition, by the metal intermediate layer MIL, the first-first emission layer 2221-1 may be separated from the first-second emission layer 2221-2, the second-first emission layer 2222-1 may be separated from the second-second emission layer 2222-2, and the third-first emission layer 2223-1 may be separated from the third-second emission layer 2223-2. Accordingly, by the metal intermediate layer MIL, a phenomenon in which the first-second emission layer 2221-2 penetrates into the first-first emission layer 2221-1 may be reduced, a phenomenon in which the second-second emission layer 2222-2 penetrates into the second-first emission layer 2222-1 may be reduced, and a phenomenon in which the third-second emission layer 2223-2 penetrates into the third-first emission layer 2223-1 may be reduced.

In an embodiment, the metal intermediate layer MIL may include at least one material from Al and Mo, for example. However, this is an illustrative embodiment, and the metal intermediate layer MIL may include various materials, as described above with reference to FIG. 4.

The opposite electrode 230 may be spaced apart from the side surface SS1 of the first bank portion P2151. The opposite electrode 230 may contact the side surface SS2 of the second bank portion P2152. At least a portion of the opposite electrode 230 may be accommodated in the second bank opening OP2152. The opposite electrode 230 may be in direct contact with an upper surface SS3 of the second bank portion P2152. The first hole transport layer HTL1, the first electron transport layer ETL1, the charge generation layer 224, the second hole transport layer HTL2, and the second electron transport layer ETL2 may each be spaced apart from the upper surface SS3 of the second bank portion P2152. The first-first emission layer 2221-1, the first-second emission layer 2221-2, the second-first emission layer 2222-1, the second-second emission layer 2222-2, the third-first emission layer 2223-1, and the third-second emission layer 2223-2 may each be spaced apart from the upper surface SS3 of the second bank portion P2152.

FIG. 8 shows an embodiment in which the first to third organic light-emitting diodes OLED1, OLED2, and OLED3 have the stacked structure of FIG. 4 described above. The stacked structure of FIG. 6 or 7 described above may also be used in the first to third organic light-emitting diodes OLED1, OLED2, and OLED3.

The opposite electrode 230 may include a conductive material having a relatively low work function. In an embodiment, the opposite electrode 230 may include a (semi)transparent layer including Ag, Mg, Al, Pt, Pd, Au, Ni, Nd, Ir, Cr, Li, calcium (Ca), alloys thereof, or the like, for example. In an alternative embodiment, the opposite electrode 230 may further include a layer, such as ITO, IZO, ZnO, or In₂O₃, above the (semi)transparent layer including the materials stated above.

Because the first to third organic light-emitting diodes OLED1, OLED2, and OLED3 may be easily damaged by moisture or oxygen from the outside, and thus the first to third organic light-emitting diodes OLED1, OLED2, and OLED3 may be protected by being covered with a thin-film encapsulation layer 300. The thin-film encapsulation layer 300 may cover the display area DA and extend to a non-display area outside the display area DA. The thin-film encapsulation layer 300 may include at least one organic encapsulation layer and at least one inorganic encapsulation layer. In an embodiment, the thin-film encapsulation layer 300 may include a first inorganic encapsulation layer 310, an organic encapsulation layer 320, and a second inorganic encapsulation layer 330, for example.

The first inorganic encapsulation layer 310 may cover the opposite electrode 230 and may include silicon oxide, silicon nitride, and/or silicon oxynitride. Although not shown in the drawing, other layers, such as a capping layer or the like, may also be arranged between the first inorganic encapsulation layer 310 and the opposite electrode 230 as desired. Because the first inorganic encapsulation layer 310 is formed along an underlying structure, an upper surface of the first inorganic encapsulation layer 310 may not be flat. The organic encapsulation layer 320 may cover the first inorganic encapsulation layer 310, and unlike the first inorganic encapsulation layer 310, an upper surface of the organic encapsulation layer 320 may be formed substantially flat. In particular, the organic encapsulation layer 320 may have a substantially flat upper surface in a portion corresponding to the display area DA. The organic encapsulation layer 320 may include one or more materials selected from a group consisting of polyethylene terephthalate, polyethylene naphthalate, polycarbonate, polyimide, polyethylene sulfonate, polyoxymethylene, polyarylate, hexamethyldisiloxane, and an acrylic-based resin (e.g., polymethyl methacrylate, polyacrylic acid, or the like). The second inorganic encapsulation layer 330 may cover the organic encapsulation layer 320 and may include silicon oxide, silicon nitride, and/or silicon oxynitride.

According to the above-state multi-layered structure of the thin-film encapsulation layer 300, even when cracks occur in the thin-film encapsulation layer 300, the thin-film encapsulation layer 300 may prevent the cracks from connecting between the first inorganic encapsulation layer 310 and the organic encapsulation layer 320 or between the organic encapsulation layer 320 and the second inorganic encapsulation layer 330. Accordingly, the formation of a path, through which external moisture or oxygen, or the like penetrates into the display area DA, may be prevented or reduced.

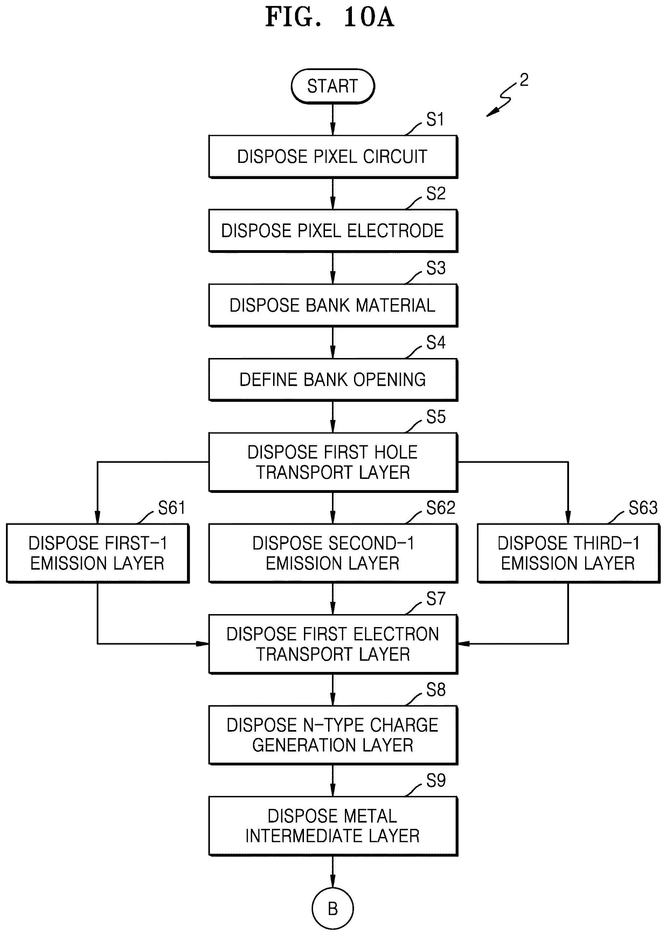

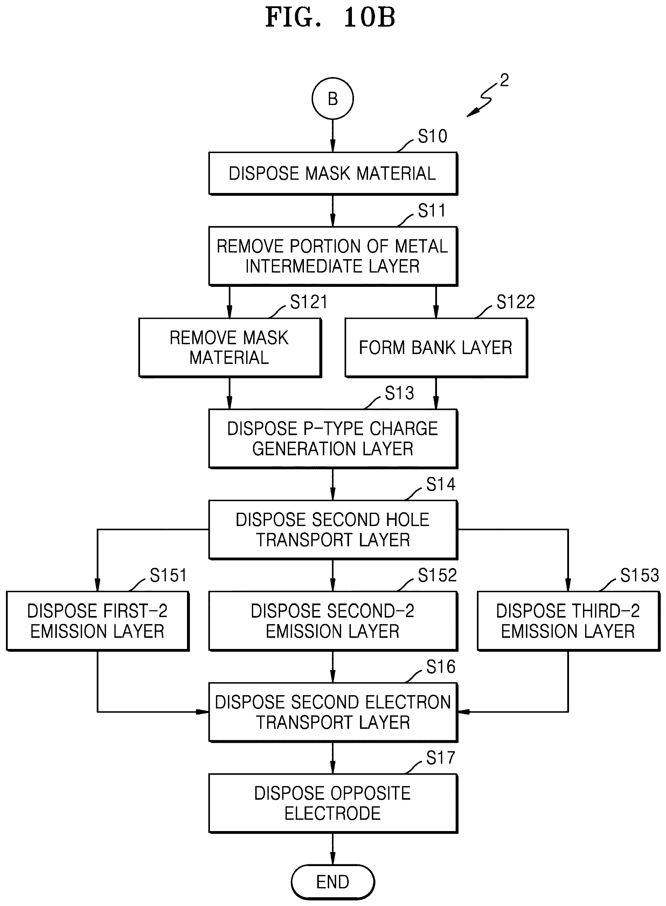

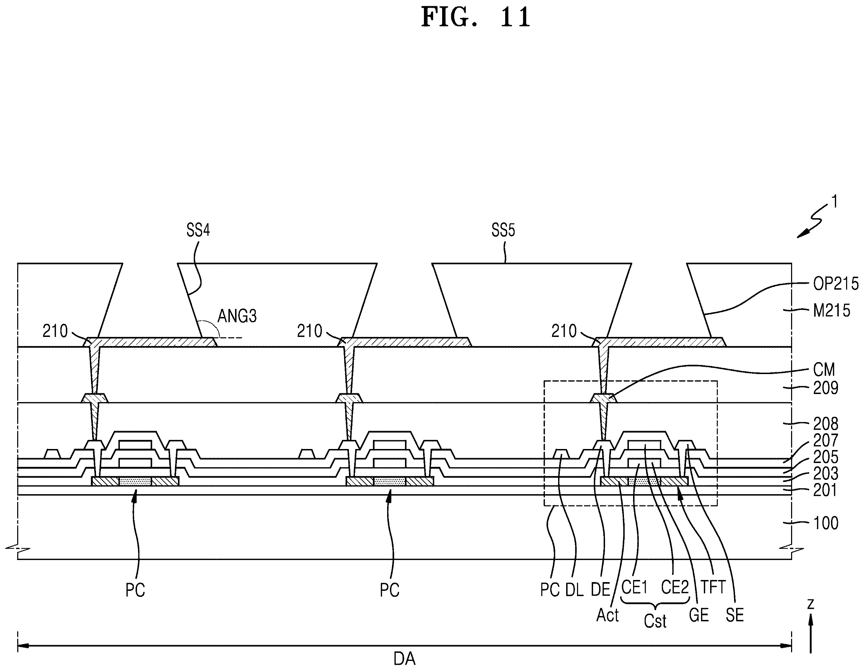

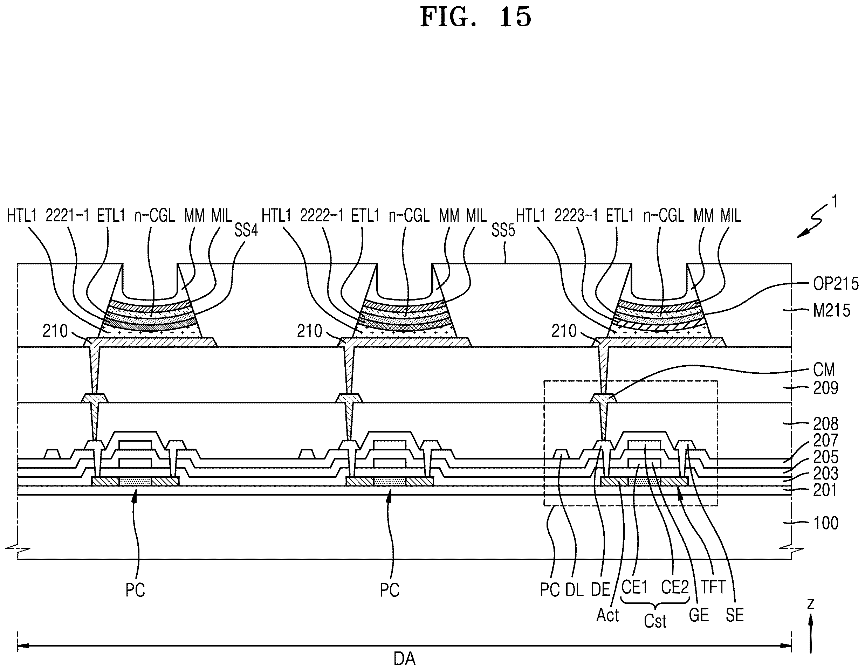

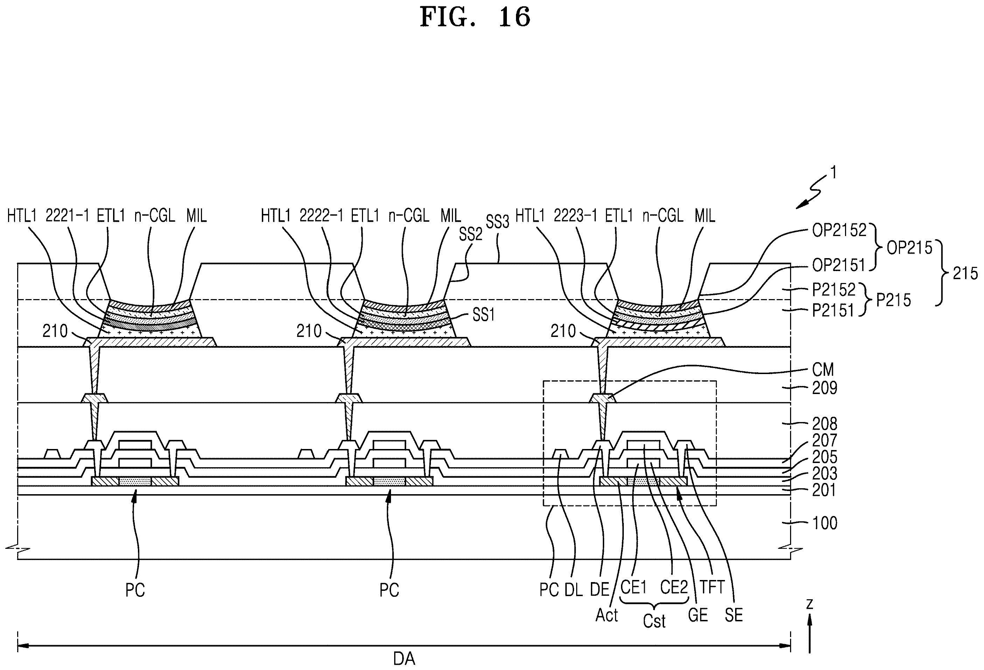

FIGS. 10A and 10B are schematic flowcharts illustrating an embodiment of a method of manufacturing the display device 1, and FIGS. 11 to 18 are schematic cross-sectional views of an embodiment of a portion of the display device 1.

Referring to FIGS. 10A to 18, the same reference numerals as those in FIGS. 8 and 9 refer to the same members, and redundant descriptions thereof are omitted.

Referring to FIGS. 10A to 18, a method 2 of manufacturing a display device is described.

First, referring to FIGS. 10A, 10B, and 11, the method 2 of manufacturing the display device may include operation S1 of disposing the pixel circuit PC on the substrate 100, operation S2 of disposing the pixel electrode 210 on the pixel circuit PC, operation S3 of disposing a bank material M215 on the pixel electrode 210, and operation S4 of defining the bank opening OP215 in the bank material M215.

The bank material M215 may be disposed on the second planarization insulating layer 209 and may cover the pixel electrode 210. The bank material M215 may include the same material as that of the bank portion P215 (refer to FIG. 8) described above with reference to FIG. 8. The bank opening OP215 may penetrate the bank material M215. At least a portion of the pixel electrode 210 may be exposed from the bank material M215 through the bank opening OP215. End portions of the pixel electrode 210 may be covered with the bank material M215, and a central portion of the pixel electrode 210 may be exposed by the bank opening OP215.

In operation S4 of defining the bank opening OP215, the bank material M215 may be reverse-tapered with respect to the substrate 100. An angle ANG3 between the substrate 100 and a side surface SS4 of the bank material M215, which defines the bank opening OP215, may be an obtuse angle. In a cross-sectional view, the angle ANG3 between the bank material M215 and the substrate 100 may be 90 degrees or more and 130 degrees or less. An upper surface SS5 of the bank material M215 may be flat.

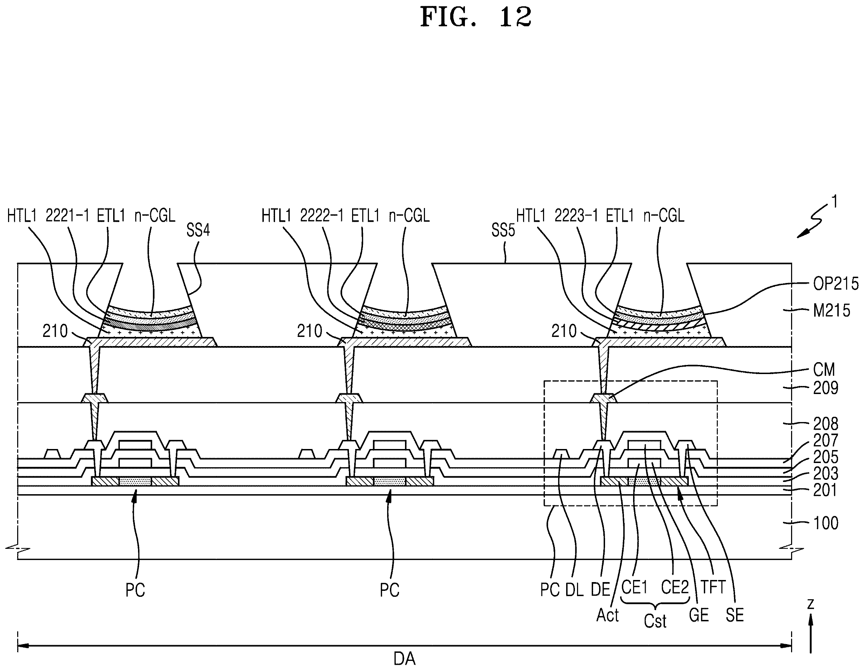

Referring to FIGS. 10A, 10B, and 12, the method 2 of manufacturing the display device may include operation S5 of disposing the first hole transport layer HTL1, operation S61 of disposing the first-first emission layer 2221-1, operation S62 of disposing the second-first emission layer 2222-1, operation S63 of disposing the third-first emission layer 2223-1, operation S7 of disposing the first electron transport layer ETL1, and operation S8 of disposing the n-type charge generation layer n-CGL.

In an embodiment, operation S61 of disposing the first-first emission layer 2221-1, operation S62 of disposing the second-first emission layer 2222-1, and operation S63 of disposing the third-first emission layer 2223-1 may be simultaneously performed, for example. In an alternative embodiment, operation S61 of disposing the first-first emission layer 2221-1, operation S62 of disposing the second-first emission layer 2222-1, and operation S63 of disposing the third-first emission layer 2223-1 may be sequentially performed. Each of the first hole transport layer HTL1, the first-first emission layer 2221-1, the second-first emission layer 2222-1, the third-first emission layer 2223-1, the first electron transport layer ETL1, and the n-type charge generation layer n-CGL may be accommodated in the bank opening OP215.

Each of operation S5 of disposing the first hole transport layer HTL1, operation S61 of disposing the first-first emission layer 2221-1, operation S62 of disposing the second-first emission layer 2222-1, operation S63 of disposing the third-first emission layer 2223-1, operation S7 of disposing the first electron transport layer ETL1, and operation S8 of disposing the n-type charge generation layer n-CGL may be performed by an inkjet process. Accordingly, each of the first hole transport layer HTL1, the first-first emission layer 2221-1, the second-first emission layer 2222-1, the third-first emission layer 2223-1, the first electron transport layer ETL1, and the n-type charge generation layer n-CGL may be disposed only in the bank opening OP215. That is, each of the first hole transport layer HTL1, the first-first emission layer 2221-1, the second-first emission layer 2222-1, the third-first emission layer 2223-1, the first electron transport layer ETL1, and the n-type charge generation layer n-CGL may be spaced apart from the upper surface SS5 of the bank material M215. In addition, each of the first hole transport layer HTL1, the first-first emission layer 2221-1, the second-first emission layer 2222-1, the third-first emission layer 2223-1, the first electron transport layer ETL1, and the n-type charge generation layer n-CGL may contact the side surface SS4 of the bank material M215. Also, an upper surface of each of the first hole transport layer HTL1, the first-first emission layer 2221-1, the second-first emission layer 2222-1, the third-first emission layer 2223-1, the first electron transport layer ETL1, and the n-type charge generation layer n-CGL may be concave.

Because the bank material M215 is provided in a reverse-tapered structure with respect to the substrate 100, a phenomenon in which the first-first emission layer 2221-1, the second-first emission layer 2222-1, and the third-first emission layer 2223-1 are connected to each other along the upper surface SS5 of the bank material M215 may be reduced. Accordingly, an interference phenomenon that occurs when the first-first emission layer 2221-1, the second-first emission layer 2222-1, and the third-first emission layer 2223-1 contact each other may be reduced.

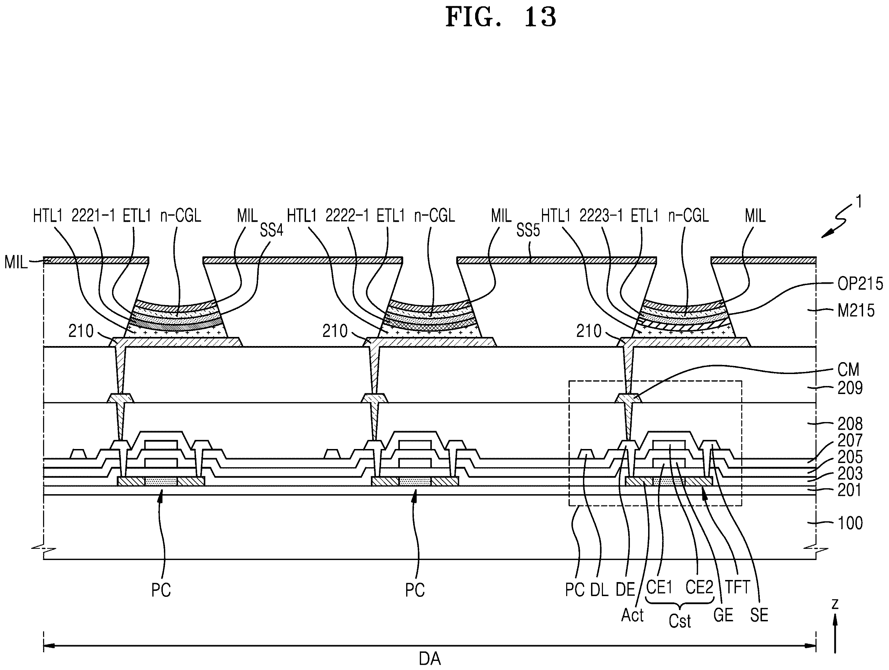

Referring to FIGS. 10A, 10B, and 13, the method 2 of manufacturing the display device may include operation S9 of disposing the metal intermediate layer MIL on the bank material M215.

At least a portion of the metal intermediate layer MIL may be accommodated in the bank opening OP215 to be disposed on the first-first emission layer 2221-1, the second-first emission layer 2222-1, and the third-first emission layer 2223-1. The metal intermediate layer MIL may contact the side surface SS4 of the bank material M215. Operation S9 of disposing the metal intermediate layer MIL may be performed by a deposition process. Accordingly, in operation S9 of disposing the metal intermediate layer MIL, a portion of the metal intermediate layer MIL may be disposed on the upper surface SS5 of the bank material M215. Because the upper surface of each of the first hole transport layer HTL1, the first-first emission layer 2221-1, the second-first emission layer 2222-1, the third-first emission layer 2223-1, the first electron transport layer ETL1, and the n-type charge generation layer n-CGL is concave, an upper surface of the metal intermediate layer MIL may be concave.

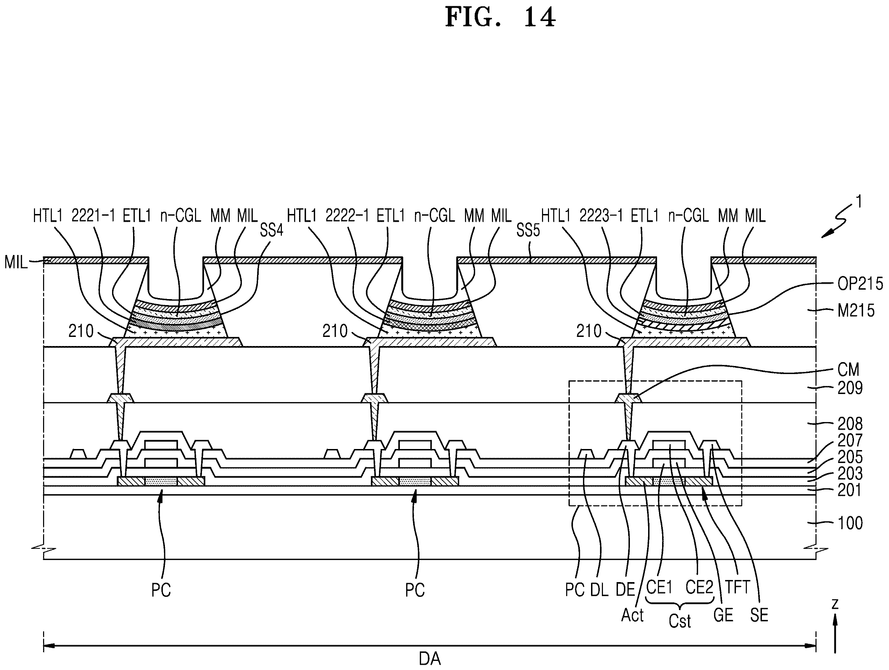

Referring to FIGS. 10A, 10B, and 14, the method 2 of manufacturing the display device may include operation S10 of disposing a mask material MM.

The mask material MM may be disposed above the n-type charge generation layer n-CGL. The mask material MM may cover each of the first hole transport layer HTL1, the first-first emission layer 2221-1, the second-first emission layer 2222-1, the third-first emission layer 2223-1, the first electron transport layer ETL1, and the n-type charge generation layer n-CGL. The mask material MM may contact the side surface SS4 of the bank material M215. The mask material MM may be spaced apart from the metal intermediate layer MIL disposed on the upper surface SS5 of the bank material M215. In an embodiment, the mask material MM may include a photoresist material, for example.

Referring to FIGS. 10A, 10B, 14, and 15, the method 2 of manufacturing the display device may include operation S11 of removing a portion of the metal intermediate layer MIL disposed on the upper surface SS5 of the bank material M215.

The metal intermediate layer MIL disposed on the upper surface SS5 of the bank material M215 may be removed by an etching process. In an embodiment, the metal intermediate layer MIL disposed on the upper surface SS5 of the bank material M215 may be removed by dry etching using an etching gas or wet etching using an etching liquid, for example.

At this time, because the first hole transport layer HTL1, the first-first emission layer 2221-1, the second-first emission layer 2222-1, the third-first emission layer 2223-1, the first electron transport layer ETL1, the n-type charge generation layer n-CGL, and the metal intermediate layer MIL, which are accommodated in the bank opening OP215, are protected by the mask material MM, and thus may not be removed. That is, the first hole transport layer HTL1, the first-first emission layer 2221-1, the second-first emission layer 2222-1, the third-first emission layer 2223-1, the first electron transport layer ETL1, the n-type charge generation layer n-CGL, and the metal intermediate layer MIL, which overlap the mask material MM, may not be removed. In other words, the first hole transport layer HTL1, the first-first emission layer 2221-1, the second-first emission layer 2222-1, the third-first emission layer 2223-1, the first electron transport layer ETL1, the n-type charge generation layer n-CGL, and the metal intermediate layer MIL, which overlap the side surface SS4 of the bank material M215, may not be removed.

Referring to FIGS. 10A, 10B, 15, and 16, the method 2 of manufacturing the display device may include operation S121 of removing the mask material MM and operation S122 of forming the bank layer 215 by etching the bank material M215.

Operation S121 of removing the mask material MM and operation S122 of forming the bank layer 215 may be simultaneously performed through an etching process. The etching process may be a process of removing organic materials remaining at the bottom by accelerating a gas, such as O₂, N₂O, or NH₃, in a plasma state.

As the mask material MM is removed, a portion of an upper portion of the bank material M215 may also be removed together. The bank material M215 after the etching process is also referred to as the bank layer 215. The bank layer 215 may include the bank portion P215 and define the bank opening OP215, the bank portion P215 may include the first bank portion P2151 and the second bank portion P2152 on the first bank portion P2151, and the bank opening OP215 may include the first bank opening OP2151 disposed in the first bank portion P2151 and the second bank opening OP2152 disposed in the second bank portion P2152.

As the bank material M215 is etched according to the etching process, the second bank portion P2152 disposed on an upper portion of the bank layer 215 may be tapered with respect to the substrate 100. That is, in operation S122 of forming the bank layer 215, the first bank portion P2151 reverse-tapered with respect to the substrate 100 and the second bank portion P2152 tapered with respect to the substrate 100 may be formed. As the bank material M215 is etched, the bank material M215 is divided into the first bank portion P2151 and the second bank portion P2152, and thus the first bank portion P2151 and the second bank portion P2152 may be integrally provided and may include the same material as each other.

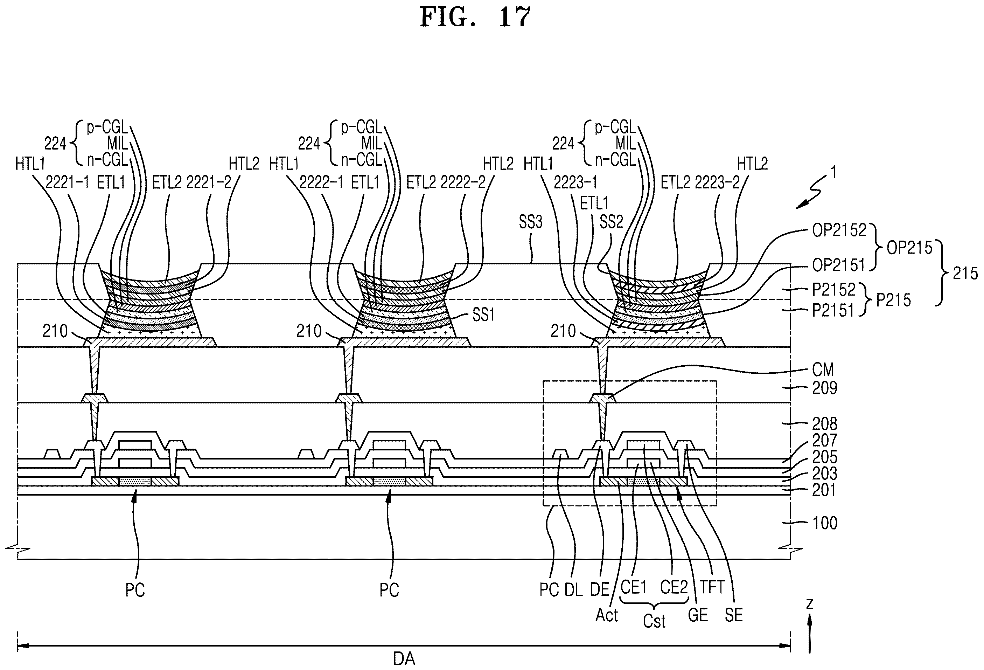

Referring to FIGS. 10A, 10B, and 17, the method 2 of manufacturing the display device may include operation S13 of disposing the p-type charge generation layer p-CGL, operation S14 of disposing the second hole transport layer HTL2, operation S151 of disposing the first-second emission layer 2221-2, operation S152 of disposing the second-second emission layer 2222-2, operation S153 of disposing the third-second emission layer 2223-2, and operation S16 of disposing the second electron transport layer ETL2.

In an embodiment, operation S151 of disposing the first-second emission layer 2221-2, operation S152 of disposing the second-second emission layer 2222-2, and operation S153 of disposing the third-second emission layer 2223-2 may be simultaneously performed, for example. In an alternative embodiment, operation S151 of disposing the first-second emission layer 2221-2, operation S152 of disposing the second-second emission layer 2222-2, and operation S153 of disposing the third-second emission layer 2223-2 may be sequentially performed. Each of the p-type charge generation layer p-CGL, the second hole transport layer HTL2, the first-second emission layer 2221-2, the second-second emission layer 2222-2, the third-second emission layer 2223-2, and the second electron transport layer ETL2 may be accommodated in the bank opening OP215.

Each of operation S13 of disposing the p-type charge generation layer p-CGL, operation S14 of disposing the second hole transport layer HTL2, operation S151 of disposing the first-second emission layer 2221-2, operation S152 of disposing the second-second emission layer 2222-2, operation S153 of disposing the third-second emission layer 2223-2, and operation S16 of disposing the second electron transport layer ETL2 may be performed by an inkjet process. Accordingly, each of the p-type charge generation layer p-CGL, the second hole transport layer HTL2, the first-second emission layer 2221-2, the second-second emission layer 2222-2, the third-second emission layer 2223-2, and the second electron transport layer ETL2 may be accommodated only in the bank opening OP215. That is, each of the p-type charge generation layer p-CGL, the second hole transport layer HTL2, the first-second emission layer 2221-2, the second-second emission layer 2222-2, the third-second emission layer 2223-2, and the second electron transport layer ETL2 may be spaced apart from the upper surface SS3 of the second bank portion P2152. In addition, each of the p-type charge generation layer p-CGL, the second hole transport layer HTL2, the first-second emission layer 2221-2, the second-second emission layer 2222-2, the third-second emission layer 2223-2, and the second electron transport layer ETL2 may contact the side surface SS2 of the second bank portion P2152. Also, an upper surface of each of the p-type charge generation layer p-CGL, the second hole transport layer HTL2, the first-second emission layer 2221-2, the second-second emission layer 2222-2, the third-second emission layer 2223-2, and the second electron transport layer ETL2 may be concave.

The first electron transport layer ETL1 and the second hole transport layer HTL2 may be separated by the metal intermediate layer MIL. Accordingly, a phenomenon in which the solvent of the second hole transport layer HTL2 penetrates into the first electron transport layer ETL1 may be reduced by the metal intermediate layer MIL.

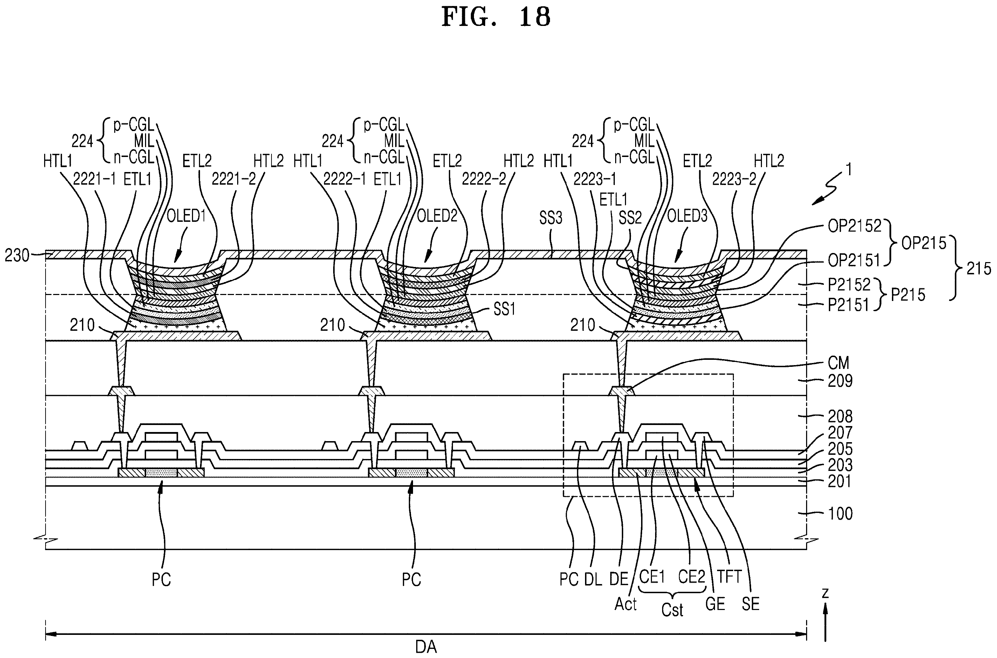

Referring to FIGS. 10A, 10B, and 18, the method 2 of manufacturing the display device may include operation S17 of disposing the opposite electrode 230 on the bank layer 215. The opposite electrode 230 may cover the bank portion P215, and at least a portion of the opposite electrode 230 may be accommodated in the bank opening OP215 (particularly, the second bank opening OP2152). The opposite electrode 230 may cover the second electron transport layer ETL2. In operation S17 of disposing the opposite electrode 230, the opposite electrode 230 may be spaced apart from the side surface SS1 of the first bank portion P2151 and the side surface SS2 of the second bank portion P2152. In operation S17 of disposing the opposite electrode 230, the opposite electrode 230 may be in direct contact with the upper surface SS3 of the second bank portion P2152.

The opposite electrode 230 may be integrally provided in the display area DA. Because the second bank portion P2152 is provided in a tapered structure, the opposite electrode 230 may be provided as one common layer across the first to third organic light-emitting diodes OLED1, OLED2, and OLED3 without being disconnected. That is, a short-circuit phenomenon of the opposite electrode 230 may be reduced.

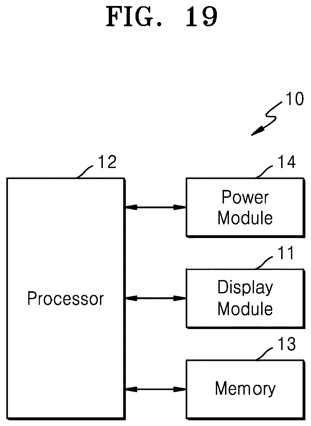

FIG. 19 is a block diagram of an embodiment of an electronic device 10.

Referring to FIG. 19, the electronic device 10 in an embodiment may include a display module 11, a processor 12, a memory 13, and a power module 14.

The processor 12 may include at least one of a central processing unit ("CPU"), an application processor ("AP"), a graphics processing unit ("GPU"), a communication processor ("CP"), an image signal processor ("ISP"), and a controller.

Data information desired for an operation of the processor 12 or the display module 11 may be stored in the memory 13. When the processor 12 executes an application stored in the memory 13, an image data signal and/or input control signal may be transmitted to the display module 11, and the display module 11 may process the received signal and output image information through a display screen.

The power module 14 may include a power supply module, such as a power adapter or a battery device, and a power conversion module that generates power desired for an operation of the electronic device 10 by converting power supplied by the power supply module.

At least one of the configurations of the electronic device 10 described above may be included in the display device in the embodiments described above. In addition, some of the individual modules functionally included within a module may be included in the display device, and remaining (the other) individual modules may also be provided separately from the display device. In an embodiment, the display device may include the display module 11, and the processor 12, the memory 13, and the power module 14 may be provided in a form of other devices within the electronic device 10 instead of the display device, for example.

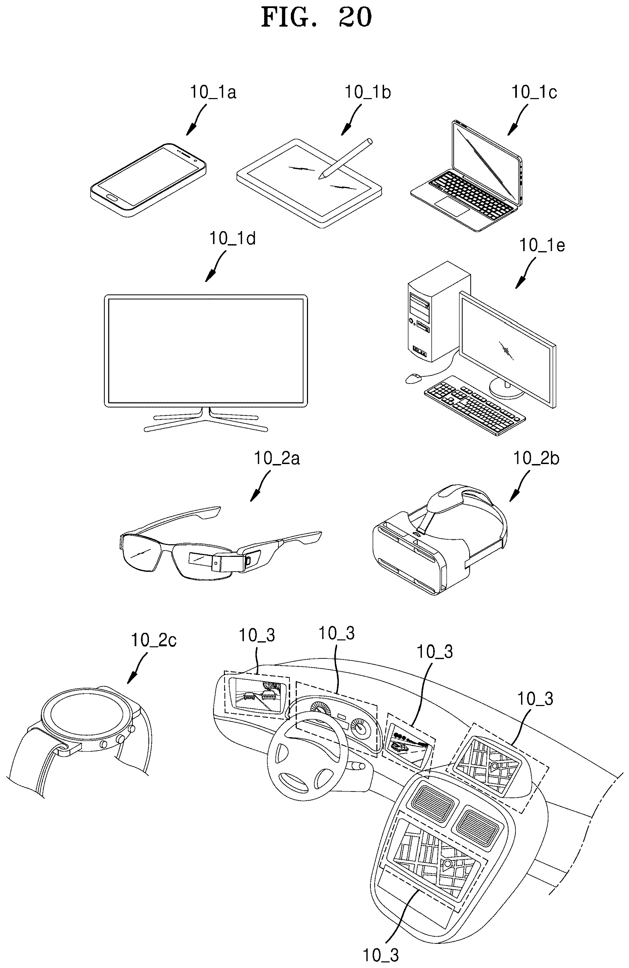

FIG. 20 shows schematic diagrams of embodiments of electronic devices.

Referring to FIG. 20, various electronic devices to which display devices in embodiments are applied may not only include electronic devices for image display, such as a smartphone 10_1a, a tablet personal computer 10_1b, a laptop 10_1c, a television ("TV") 10_1d, a desk monitor 10_1e, but may also include wearable electronic devices including display modules, such as smart glasses 10_2a, a head-mounted display 10_2b, a smart watch 10_2c, or the like, and electronic devices 10_3 for a vehicle including a display module, such as a dashboard of a vehicle, a center fascia, a center information display ("CID") disposed on a dashboard, a room mirror display, or the like.

By embodiments, the durability and quality of a display device may be improved, and processes of a method of manufacturing the display device may be simplified.

Effects of the disclosure are not limited to the effects mentioned above, and other effects not mentioned will be clearly understood by one of ordinary in the art from the description of the claims.

**It** should be understood that embodiments described herein should be considered in a descriptive sense only and not for purposes of limitation. Descriptions of features or advantages within each embodiment should typically be considered as available for other similar features or advantages in other embodiments. While embodiments have been described with reference to the drawing figures, it will be understood by those of ordinary skill in the art that various changes in form and details may be made therein without departing from the scope as defined by the following claims.

## Claims

1. A display device (1) comprising:
a substrate (100);
a pixel circuit (PC) disposed on the substrate (100);
a pixel electrode (210) disposed on the pixel circuit (PC);
a bank layer (215) defining a bank opening (OP215) exposing the pixel electrode (210), the bank layer (215) comprising:
a bank portion (P215) disposed on the pixel electrode (210), the bank portion (P215) comprising:
a first bank portion (P2151) reverse-tapered with respect to the substrate (100); and
a second bank portion (P2152) disposed on the first bank portion (P2151) and tapered with respect to the substrate (100);
a first-first emission layer (2221-1) accommodated in the bank opening (OP215) and disposed on the pixel electrode (210);
a charge generation layer (224) accommodated in the bank opening (OP215) and disposed on the first-first emission layer (2221-1), the charge generation layer (224) comprising:
an n-type charge generation layer (n-CGL);
a metal intermediate layer (MIL) disposed on the n-type charge generation layer (n-CGL); and
a p-type charge generation layer (p-CGL) disposed on the metal intermediate layer (MIL);
a first-second emission layer (2221-2) accommodated in the bank opening (OP215) and disposed on the charge generation layer (224); and
an opposite electrode (230) covering the bank portion (P215) and disposed on the first-second emission layer (2221-2).

2. The display device of claim 1, wherein the opposite electrode (230) is spaced apart from a side surface of the first bank portion (P2151) and contacts a side surface of the second bank portion (P2152); and/or
wherein the opposite electrode (230) is in direct contact with an upper surface of the second bank portion (P2152).

3. The display device of claim 1 or 2, wherein the first-first emission layer (2221-1) contacts the side surface of the first bank portion (P2151), and
the first-second emission layer (2221-2) contacts the side surface of the second bank portion (P2152).

4. The display device of any one of claims 1 to 3, wherein each of the first-first emission layer (2221-1), the charge generation layer (224), and the first-second emission layer (2221-2) is spaced apart from an upper surface of the second bank portion (P2152).

5. The display device of any one of claims 1 to 4, further comprising a first hole transport layer (HTL1) disposed between the pixel electrode (210) and the first-first emission layer (2221-1);
a first electron transport layer (ETL1) disposed between the first-first emission layer (2221-1) and the charge generation layer (224);
a second hole transport layer (HTL2) disposed between the charge generation layer (224) and the first-second emission layer (2221-2); and
a second electron transport layer (ETL2) disposed between the first-second emission layer (2221-2) and the opposite electrode (230).

6. The display device of claim 5, wherein each of the first hole transport layer (HTL1), the first electron transport layer (ETL1), the second hole transport layer (HTL2), and the second electron transport layer (ETL2) is spaced apart from an upper surface of the second bank portion (P2152).

7. An electronic device (10) comprising:
the display device according to any one of claims 1 to 6, wherein in the display device, a plurality of pixels are disposed.

8. The electronic device (10) of claim 7, wherein the metal intermediate layer (MIL) comprises at least one material from aluminum and molybdenum.

9. The electronic device (10) of claim 7 or 8, wherein, in a cross-sectional view, an angle between a side surface of the first bank portion (P2151) and an upper surface of the substrate (100) is 90 degrees or more and 130 degrees or less, and/or
wherein, in the cross-sectional view, an angle between a side surface of the second bank portion (P2152) and the upper surface of the substrate (100) is 60 degrees or more and 70 degrees or less.

10. A method (2) of manufacturing a display device (1), the method comprising the following steps:
disposing (S1) a pixel circuit (PC) on a substrate (100);
disposing (S2) a pixel electrode (210) on the pixel circuit (PC);
disposing (S3) a bank material (M215) on the pixel electrode (210);
defining (S4) a bank opening (OP215) in the bank material (M215) to expose at least a portion of the pixel electrode (210);
disposing (S61) a first-first emission layer (2221-1) on the pixel electrode (210) to be accommodated in the bank opening (OP215);
disposing (S9) a metal intermediate layer (MIL) on the bank material (M215) so that at least a portion of the metal intermediate layer (MIL) is disposed on the first-first emission layer (2221-1);
disposing (S10) a mask material (MM) in the bank opening (OP215) to cover the metal intermediate layer (MIL);
removing (S11) a portion of the metal intermediate layer (MIL) disposed on an upper surface of the bank material (M215);
removing (S121) the mask material (MM);
forming (S122) a bank layer (215) by etching the bank material (M215);
disposing (S151) a first-second emission layer (2221-2) on the metal intermediate layer (MIL) to be accommodated in the bank opening (OP215); and
disposing (S17) an opposite electrode (230) on the bank layer (215).

11. The method (2) of claim 10, wherein the step (S61) of disposing the first-first emission layer (2221-1) and the step (S151) of disposing the first-second emission layer (2221-2) are performed by an inkjet process.

12. The method (2) of claim 10 or 11, wherein, in the step (S61) of disposing the first-first emission layer (2221-1), the first-first emission layer (2221-1) is spaced apart from the upper surface of the bank material (M215).

13. The method (2) of any one of claims 10 to 12, wherein, in the step (S151) of disposing the first-second emission layer (2221-2), the first-second emission layer (2221-2) is spaced apart from the upper surface of the bank material (M215).

14. The method_(2) of any one of claims 10 to 13, wherein the step (S9) of disposing the metal intermediate layer (MIL) is performed by a deposition process.

15. The method_(2) of any one of claims 10 to 14, wherein, in the step (S9) of disposing the metal intermediate layer (MIL), a portion of the metal intermediate layer (MIL) is disposed on the upper surface of the bank material (M215).
